(19) **Europäisches Patentamt / European Patent Office / Office européen des brevets**

(11) **EP 4 646 071 A1**

(12) **EUROPEAN PATENT APPLICATION**
published in accordance with Art. 153(4) EPC

(43) Date of publication:
**05.11.2025 Bulletin 2025/45**

(21) Application number: **23911233.7**

(22) Date of filing: **01.08.2023**

(51) International Patent Classification (IPC):
**H10H 20/851** $^{(2025.01)}$   **C09K 11/08** $^{(2006.01)}$
**C09K 11/59** $^{(2006.01)}$   **C09K 11/61** $^{(2006.01)}$
**C09K 11/62** $^{(2006.01)}$   **C09K 11/64** $^{(2006.01)}$
**C09K 11/79** $^{(2006.01)}$   **C09K 11/80** $^{(2006.01)}$
**C09K 11/85** $^{(2006.01)}$   **F21K 9/60** $^{(2016.01)}$
**F21K 9/64** $^{(2016.01)}$   **F21S 41/125** $^{(2018.01)}$
**F21S 41/141** $^{(2018.01)}$   **F21S 41/176** $^{(2018.01)}$
**F21V 9/38** $^{(2018.01)}$

(52) Cooperative Patent Classification (CPC):
**C09K 11/0883; C09K 11/08; C09K 11/59;**
**C09K 11/61; C09K 11/617; C09K 11/62;**
**C09K 11/64; C09K 11/77; C09K 11/7734;**
**C09K 11/77346; C09K 11/77348; F21K 9/60;**
**F21K 9/64; F21S 41/125; F21S 41/141;**   (Cont.)

(86) International application number:
**PCT/JP2023/028194**

(87) International publication number:
**WO 2024/142449 (04.07.2024 Gazette 2024/27)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **27.12.2022 JP 2022210188**

(71) Applicants:
• **Mitsubishi Chemical Corporation**
  **Tokyo 100-8251 (JP)**

• **National Institute for Materials Science**
  **Tsukuba-shi, Ibaraki 305-0047 (JP)**

(72) Inventors:
• **INATA Yuhei**
  **Tokyo 100-8251 (JP)**
• **KURUSHIMA Tomoyuki**
  **Tokyo 100-8251 (JP)**
• **HIROSAKI Naoto**
  **Tsukuba-shi, Ibaraki 305-0047 (JP)**

(74) Representative: **Hoffmann Eitle**
**Patent- und Rechtsanwälte PartmbB**
**Arabellastraße 30**
**81925 München (DE)**

(54) **LIGHT-EMITTING DEVICE, LIGHTING DEVICE, IMAGE DISPLAY DEVICE, AND VEHICULAR INDICATOR LAMP**

(57)    An object of the present invention is to provide a light-emitting device, an illumination device, an image display device, and/or an indicator lamp for a vehicle which is favorable in any one or more of color rendering, color reproducibility, conversion efficiency, safety, and a contrast. The present invention relates to a light-emitting device including a first luminescent material and a second luminescent material which emits visible light by irradiation with light from the first luminescent material, in which the second luminescent material contains at least a red phosphor which satisfies the following (A) and (B):

(A) An emission spectrum has at least one emission peak having a full width at half maximum (FWHM) of 20 nm or more and 65 nm or less, and
(B) Chromaticity coordinates of a light emission color are present between two straight lines represented by the following equation (a) and equation (b) based on coordinates represented by (x, y) in a CIE 1931 chromaticity coordinate system:

$$y = 0.992\text{-}x \qquad (a),$$

EP 4 646 071 A1

$$y = 1.000\text{-}x \qquad (b),$$

and

$$0.290 \leq y \leq 0.350.$$

*FIG. 2A*

(52) Cooperative Patent Classification (CPC): (Cont.)
**F21S 41/176; F21V 9/38; G02B 5/20; H05B 33/14;
H10H 20/851; H10K 50/12;** F21S 43/14;
F21W 2102/00; F21W 2102/30; F21W 2103/15;
F21W 2103/20; F21W 2103/35; F21W 2103/45;
F21Y 2115/10

## Description

TECHNICAL FIELD

The present invention relates to a light-emitting device, an illumination device, an image display device, and an indicator lamp for a vehicle.

BACKGROUND ART

In recent years, a demand for a light-emitting device, an illumination device, an image display device, and/or an indicator lamp for a vehicle using an LED has increased in response to a trend toward energy conservation. The LED used in such devices is, for example, a white light-emitting LED in which a phosphor is disposed on an LED chip that emits light in blue or near-ultraviolet wavelengths.

An LED using, on a blue LED chip, a nitride phosphor that emits red light and a phosphor that emits green light, with blue light from the blue LED chip as excitation light, has been used for this type of white light-emitting LED in recent years. There is a demand for an LED having high color rendering, color reproducibility, and/or emission efficiency.

As a red phosphor contained in a light-emitting device, for example, a KSF phosphor represented by a formula: $K_2$(Si, Ti)$F_6$:Mn, $K_2Si_{1-x}Na_xAl_xF_6$:Mn $(0 < x < 1)$ (see, for example, Non-Patent Literature 1), a S/CASN phosphor represented by a formula: (Sr, Ca)AlSiN$_3$:Eu (see, for example, Patent Literature 1), and a 2-5-8 phosphor represented by a formula: $Ca_2Si_5N_8$:Eu (see, for example, Non-Patent Literature 2) are known.

The KSF phosphor is activated with Mn and is therefore harmful, and there is a demand for a phosphor which is not harmful to the human body and the environment. From another viewpoint, for example, as shown in Fig. 4 in Non-Patent Literature 1, the KSF phosphor has a fluorescence decay time of several milliseconds which is long (see, for example, Non-Patent Literature 1). This means that an illumination device equipped with KSF, especially in a high-output device, may experience brightness saturation and have a decrease in conversion efficiency, or that a contrast of an image display device (display) equipped with KSF may be reduced.

In addition, the S/CASN phosphor and the 2-5-8 phosphor often have comparatively broad peak width at half-height at emission spectrum (in other words, "spectral half-width", "A full width at half maximum" or "FWHM") of about 80 nm to 90 nm (see, for example, Patent Literature 1 and Non-Patent Literature 2). Therefore, a light-emitting device which mainly uses these phosphors for red often has a large emission intensity in, for example, a wavelength region of 700 nm or more where relative visibility is low, and may have a decrease in conversion efficiency of emission efficiency.

CITATION LIST

PATENT LITERATURE

Patent Literature 1: JP2006-008721A

NON PATENT LITERATURE

Non-Patent Literature 1: J. Mater. Chem. C, 2015, Vol. 3, Issue 21, p. 5484-5489
Non-Patent Literature 2: Chemistry Letters, 2006, Vol. 35, No. 3, p. 334-335

SUMMARY OF INVENTION

TECHNICAL PROBLEM

Based on the above problems, in one aspect, an object of the present invention is to provide a light-emitting device, an illumination device, an image display device, and/or an indicator lamp for a vehicle which are favorable in any one or more of color rendering, color reproducibility, conversion efficiency, safety, and a contrast.

SOLUTION TO PROBLEM

After intensive study, the present inventors have found that the above problems can be solved by a light-emitting device including at least a light source and a red phosphor, in which the red phosphor includes a red phosphor whose light emission color has a chromaticity coordinate within a specific range, and the red phosphor has a full width at half maximum in an emission spectrum within a certain range. Thus, the present invention has been completed. Some non-limiting embodiments are shown below. Note that the present invention also includes embodiments which further include some or all of features of one or more other embodiments with respect to any of the embodiments described below.

<1> A light-emitting device comprising

a first luminescent material; and
a second luminescent material which emits visible light by irradiation with light from the first luminescent material, wherein
the second luminescent material contains at least a red phosphor which satisfies the following (A) and (B):

(A) an emission spectrum has at least one emission peak having a full width at half maximum (FWHM) of 20 nm or more and 65 nm or less; and
(B) a chromaticity coordinate of a light emission color is present between two straight lines represented by the following equation (a) and equation (b) based on coordinates represented by (x, y) in a CIE 1931 chromaticity coordinate system:

$$\text{(a)}\ y = 0.992\text{-x,}$$

$$\text{(b)}\ y = 1.000\text{-x,}$$

and

$$0.290 \leq y \leq 0.350.$$

<2> The light-emitting device according to the above <1>, in which a value of y in the chromaticity coordinate of red light emitted by the red phosphor is 0.300 or more.
<3> The light-emitting device according to the above <1> or <2>, in which a value of y in the chromaticity coordinate of red light emitted by the red phosphor is 0.310 or less.
<4> The light-emitting device according to any one of the above <1> to <3>, in which the red phosphor includes a phosphor which does not substantially include Mn.
<5> The light-emitting device according to any one of the above <1> to <4>, in which the emission spectrum of the red phosphor has at least one emission peak having an emission peak wavelength of 648 nm or less.
<6> The light-emitting device according to any one of the above <1> to <5>, in which internal quantum efficiency of the red phosphor is 30% or more.
<7> The light-emitting device according to any one of the above <1> to <6>, in which the red phosphor has the full width at half maximum in the emission spectrum of 57 nm or less.
<8> The light-emitting device according to any one of the above <1> to <7>, in which the red phosphor has an emission peak wavelength x (nm) and a full width at half maximum y (nm) in the emission spectrum satisfying a relationship: $y \leq 184\text{-}0.2x$.
<9> The light-emitting device according to any one of the above <1> to <8>, in which the red phosphor comprises at least a phosphor containing a crystal phase having a composition represented by the following formula [1]:

$$\text{Re}_x\text{MA}_a\text{MB}_b\text{MC}_c\text{N}_d\text{X}_e \qquad [1]$$

wherein in formula [1],

MA includes one or more elements selected from the group consisting of Sr, Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

<10> The light-emitting device according to any one of the above <1> to <9>, in which the red phosphor comprises at least a phosphor containing a crystal phase having a composition represented by the following formula [2]:

$$Re_x MA_a MB_b (MC'_{1-y} MD_y)_c N_d X_e \qquad [2]$$

wherein in formula [2], MA includes one or more elements selected from the group consisting of Sr, Ca, Ba, Na, K, Y, Gd, and La,
MB includes one or more elements selected from the group consisting of Li, Mg, and Zn,
MC' is Al, MD includes one or more elements selected from the group consisting of Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

<11> The light-emitting device according to any one of the above <1> to <9>, in which the red phosphor comprises at least a phosphor containing a crystal phase having a composition represented by the following formula [3]:

$$Re_x MA_a MB_b MC_c (N,O)_d X_e \qquad [3]$$

wherein in formula [3], (N,O) means containing N and O,
MA includes one or more elements selected from the group consisting of Sr, Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,

Re includes one or more elements selected from the group consisting of Eu, Ce, Pr, Tb, and Dy, and a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

<12> The light-emitting device according to any one of the above <1> to <8> and <10>, in which the red phosphor comprises at least a phosphor containing a crystal phase having a composition represented by the following formula [4]:

$$Re_x MA_a MB_b (MC'_{1-y} MD_y)_c (N,O)_d X_e \qquad [4]$$

wherein in formula [4], (N,O) means containing N and O,
MA includes one or more elements selected from the group consisting of Sr, Ca, Ba, Na, K, Y, Gd, and La,
MB includes one or more elements selected from the group consisting of Li, Mg, and Zn,
MC' is Al,
MD includes one or more elements selected from the group consisting of Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

<13> The light-emitting device according to any one of the above <1> to <12>, in which the second luminescent material further comprises a yellow phosphor and/or a green phosphor.

<14> The light-emitting device according to any one of the above <1> to <13>, in which the yellow phosphor and/or the green phosphor comprises any one or more of a garnet type phosphor, a silicate type phosphor, a nitride phosphor, and an oxynitride phosphor.

<15> An illumination device comprising the light-emitting device according to any one of the above <1> to <14> as a light source.

<16> An image display device comprising the light-emitting device according to any one of the above <1> to <14> as a light source.

<17> An indicator lamp for a vehicle comprising the light-emitting device according to any one of the above <1> to <14> as a light source.

<18> A red phosphor satisfying at least the following (A) and (B):

(A) an emission spectrum has at least one emission peak having a full width at half maximum (FWHM) of 20 nm or more and 65 nm or less, and

(B) a chromaticity coordinate of a light emission color is present between two straight lines represented by the following equation (a) and equation (b) based on coordinates represented by (x, y) in a CIE 1931 chromaticity coordinate system:

$$y = 0.992\text{-}x \qquad (a),$$

$$y = 1.000\text{-}x \qquad (b),$$

and

$$0.290 \le y \le 0.350.$$

<19> The red phosphor according to the above <18>, in which a value of y of red light in the chromaticity coordinate is 0.300 or more.

<20> The red phosphor according to the above <18> or <19>, in which the value of y of the red light in the chromaticity coordinate is 0.310 or less.

<21> The red phosphor according to any one of the above <18> to <20>, in which a phosphor which does not substantially include Mn is contained.

<22> The red phosphor according to any one of the above <18> to <21>, in which the emission spectrum has at least one emission peak having an emission peak wavelength of 648 nm or less.

<23> The red phosphor according to any one of the above <18> to <22>, in which internal quantum efficiency is 30% or more.

<24> The red phosphor according to any one of the above <18> to <23>, in which the full width at half maximum in the emission spectrum is 57 nm or less.

<25> The red phosphor according to any one of the above <18> to <24>, in which an emission peak wavelength x (nm) and a full width at half maximum y (nm) in the emission spectrum satisfy a relationship: $y \le 184\text{-}0.2x$.

<26> The red phosphor according to any one of the above <18> to <25>, comprising at least a phosphor containing a crystal phase having a composition represented by the following formula [1]:

$$Re_x MA_a MB_b MC_c N_d X_e \qquad [1]$$

wherein in formula [1], MA includes one or more elements selected from the group consisting of Sr, Ca, Ba, Na, K, Y, Gd, and La,

MB includes one or more elements selected from the group consisting of Li, Mg, and Zn,

MC includes one or more elements selected from the group consisting of Al, Si, Ga, In, and Sc,

X includes one or more elements selected from the group consisting of F, Cl, Br, and I,

Re includes one or more elements selected from the group consisting of Eu, Ce, Pr, Tb, and Dy, and

a, b, c, d, e, and x respectively satisfy the following expressions:

$$0.7 \le a \le 1.3$$

$$0.7 \le b \le 1.3$$

$$2.4 \leq c \leq 3.6$$

$$3.2 \leq d \leq 4.8$$

$$0.0 \leq e \leq 0.2$$

$$0.0 < x \leq 0.2.$$

<27> The red phosphor according to any one of the above <18> to <26>, comprising at least a phosphor containing a crystal phase having a composition represented by the following formula [2]:

$$Re_x MA_a MB_b (MC'_{1-y} MD_y)_c N_d X_e \qquad [2]$$

wherein in formula [2], MA includes one or more elements selected from the group consisting of Sr, Ca, Ba, Na, K, Y, Gd, and La,
MB includes one or more elements selected from the group consisting of Li, Mg, and Zn,
MC' is Al,
MD includes one or more elements selected from the group consisting of Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

<28> The red phosphor according to any one of the above <18> to <26>, comprising at least a phosphor containing a crystal phase having a composition represented by the following formula [3]:

$$Re_x MA_a MB_b MC_c (N,O)_d X_e \qquad [3]$$

wherein in formula [3], (N,O) means containing N and O,
MA includes one or more elements selected from the group consisting of Sr, Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

<29> The red phosphor according to any one of the above <18> to <26>, comprising at least a phosphor containing a crystal phase having a composition represented by the following formula [4]:

$$Re_x MA_a MB_b (MC'_{1-y} MD_y)_c (N,O)_d X_e \qquad [4]$$

wherein in formula [4], (N,O) means containing N and O,
MA includes one or more elements selected from the group consisting of Sr, Ca, Ba, Na, K, Y, Gd, and La,
MB includes one or more elements selected from the group consisting of Li, Mg, and Zn,
MC' is Al,
MD includes one or more elements selected from the group consisting of Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

EFFECTS OF INVENTION

In a plurality of embodiments, the present invention can provide a light-emitting device, an illumination device, an image display device, and/or an indicator lamp for a vehicle which are favorable in any one or more of color rendering, color reproducibility, conversion efficiency, safety, and a contrast.

BRIEF DESCRIPTION OF DRAWINGS

[Fig. 1] Fig. 1 is graph obtained by plotting colors of samples, i.e., the phosphors 2 to 9 used in Examples and the phosphors 1 and 10 used in Comparative Examples 1 to 6, based on coordinates expressed as (x, y) in the CIE chromaticity coordinates.
[Fig. 2A] Fig. 2A is a graph showing emission intensity of the phosphors 2 to 5 when an emission intensity of the phosphor 1 at an emission peak wavelength is set to 1.
[Fig. 2B] Fig. 2B is a graph showing emission intensity of the phosphors 6 to 10 when the emission intensity of the phosphor 1 at an emission peak wavelength is set to 1.
[Fig. 3] Fig. 3 is a graph showing relative emission intensity when emission intensity of a reference phosphor and the phosphors 1, 2, 5, 8, and 9 at an emission peak wavelength are set to 1 respectively.

[Fig. 4A] Fig. 4A is a graph showing simulation results of relative emission intensity of white LEDs of Comparative Example 1, Example 1, and Example 2 at the CIE chromaticity coordinates (0.437, 0.404) and a color temperature of 3000 K.

[Fig. 4B] Fig. 4B is a graph showing simulation results of relative emission intensity of white LEDs of Comparative Example 3, Comparative Example 4, Example 3, and Example 4 at the CIE chromaticity coordinates (0.437, 0.404) and a color temperature of 3000 K.

[Fig. 4C] Fig. 4C is a graph showing simulation results of relative emission intensity of white LEDs of Comparative Example 1, Example 5, and Example 6 at the CIE chromaticity coordinates (0.437, 0.404) and a color temperature of 3000 K.

[Fig. 4D] Fig. 4D is a graph showing simulation results of relative emission intensity of white LEDs of Comparative Example 1, Example 7, and Example 15 at CIE chromaticity coordinates (0.437, 0.404) and a color temperature of 3000 K.

[Fig. 5A] Fig. 5A is a graph showing simulation results of relative emission intensity when emission intensity of the white LEDs of Comparative Example 1, Comparative Example 4, Example 1, and Example 2 at an emission peak wavelength are set to 1 respectively at the CIE chromaticity coordinates (0.437, 0.404) and a color temperature of 3000 K.

[Fig. 5B] Fig. 5B is a graph showing simulation results of relative emission intensity when emission intensity of the white LEDs of Comparative Example 1, Comparative Example 3, Comparative Example 4, Example 3, and Example 4 at an emission peak wavelength are set to 1 respectively at the CIE chromaticity coordinates (0.437, 0.404) and a color temperature of 3000 K.

[Fig. 5C] Fig. 5C is a graph showing simulation results of relative emission intensity when emission intensity of the white LEDs of Comparative Example 1, Comparative Example 4, Example 5, and Example 6 at an emission peak wavelength are set to 1 respectively at the CIE chromaticity coordinates (0.437, 0.404) and a color temperature of 3000 K.

[Fig. 5D] Fig. 5D is a graph showing simulation results of relative emission intensity when emission intensity of the white LEDs of Reference Example 1, Comparative Example 4, Example 7, and Example 15 at an emission peak wavelength are set to 1 respectively at the CIE chromaticity coordinates (0.437, 0.404) and a color temperature of 3000 K.

[Fig. 5E] Fig. 5E is a graph showing simulation results of relative emission intensity when emission intensity of the white LEDs of Reference Example 1, Example 3, and Example 7 at an emission peak wavelength are set to 1 respectively at the CIE chromaticity coordinates (0.437, 0.404) and a color temperature of 3000 K.

[Fig. 6A] Fig. 6A is a graph showing simulation results of relative emission intensity of white LEDs of Comparative Example 2, Example 8, and Example 9 at the CIE chromaticity coordinates (0.380, 0.377) and a color temperature of 4000 K.

[Fig. 6B] Fig. 6B is a graph showing simulation results of relative emission intensity of white LEDs of Comparative Example 5, Comparative Example 6, Example 10, and Example 11 at the CIE chromaticity coordinates (0.380, 0.377) and a color temperature of 4000 K.

[Fig. 6C] Fig. 6C is a graph showing simulation results of relative emission intensity of white LEDs of Comparative Example 2, Example 12, and Example 13 at the CIE chromaticity coordinates (0.380, 0.377) and a color temperature of 4000 K.

[Fig. 6D] Fig. 6D is a graph showing simulation results of relative emission intensity of white LEDs of Comparative Example 2, Example 14, and Example 16 at the CIE chromaticity coordinates (0.380, 0.377) and a color temperature of 4000 K.

[Fig. 7A] Fig. 7A is a graph showing simulation results of relative emission intensity when emission intensity of the white LEDs of Comparative Example 2, Comparative Example 6, Example 8, and Example 9 at an emission peak wavelength present in a region of 500 nm or more and 780 nm or less are set to 1 respectively at the CIE chromaticity coordinates (0.380, 0.377) and a color temperature of 4000 K.

[Fig. 7B] Fig. 7B is a graph showing simulation results of relative emission intensity when emission intensity of the white LEDs of Comparative Example 2, Comparative Example 5, Comparative Example 6, Example 10, and Example 11 at an emission peak wavelength present in a region of 500 nm or more and 780 nm or less are set to 1 respectively at the CIE chromaticity coordinates (0.380, 0.377) and a color temperature of 4000 K.

[Fig. 7C] Fig. 7C is a graph showing simulation results of relative emission intensity when emission intensity of the white LEDs of Comparative Example 2, Comparative Example 6, Example 12, and Example 13 at an emission peak wavelength present in a region of 500 nm or more and 780 nm or less are set to 1 respectively at the CIE chromaticity coordinates (0.380, 0.377) and a color temperature of 4000 K.

[Fig. 7D] Fig. 7D is a graph showing simulation results of relative emission intensity when emission intensity of the white LEDs of Reference Example 2, Comparative Example 6, Example 14, and Example 16 at an emission peak wavelength present in a region of 500 nm or more and 780 nm or less are set to 1 respectively at the CIE chromaticity coordinates (0.380, 0.377) and a color temperature of 4000 K.

[Fig. 7E] Fig. 7E is a graph showing simulation results of relative emission intensity when emission intensity of the white LEDs of Reference Example 2, Example 10, and Example 14 at an emission peak wavelength present in a region of 500 nm or more and 780 nm or less are set to 1 respectively at the CIE chromaticity coordinates (0.380, 0.377) and a color temperature of 4000 K.

DESCRIPTION OF EMBODIMENTS

Hereinafter, the present invention will be explained by showing embodiments and examples, but the present invention is not limited to the following embodiments, examples, and the like, and can be implemented with any modifications within the scope of the gist of the present invention.

Note that in the present description, a numerical range expressed using "to" means a range that includes numerical values written before and after "to" as an upper limit value and a lower limit value. In addition, in composition formulae of phosphors in the present description, the end of each composition formula is represented by a comma (,). Further, when a plurality of elements are listed with separation by a comma (,), it indicates that one or two or more of the listed elements may be contained in any combination and composition. For example, a composition formula "(Ca, Sr, Ba)$Al_2O_4$:Eu" inclusively indicates all of "$CaAl_2O_4$:Eu", "$SrAl_2O_4$:Eu", "$BaAl_2O_4$:Eu", "$Ca_{1-x}Sr_xAl_2O_4$:Eu", "$Sr_{1-x}Ba_xAl_2O_4$:Eu", "$Ca_{1-x}Ba_xAl_2O_4$:Eu", and "$Ca_{1-x-y}Sr_xBa_yAl_2O_4$:Eu" (where $0 < x < 1$, $0 < y < 1$, and $0 < x+y < 1$ in the formula).

In one embodiment, the present invention provides a light-emitting device including a first luminescent material and a second luminescent material which emits visible light by irradiation with light from the first luminescent material, in which the second luminescent material contains at least a red phosphor which satisfies the following (A) and (B).

In another embodiment, the present invention provides a red phosphor containing a red phosphor which satisfies the following (A) and (B).

(A) An emission spectrum has at least one emission peak having a full width at half maximum (FWHM) of 20 nm or more and 65 nm or less, and

(B) Chromaticity coordinates of a light emission color are present between two straight lines represented by the following equation (a) and equation (b) based on coordinates represented by (x, y) in a CIE 1931 chromaticity coordinate system:

$$y = 0.992\text{-}x \qquad (a),$$

$$y = 1.000\text{-}x \qquad (b),$$

and

$$0.290 \le y \le 0.350.$$

From another viewpoint, in one embodiment, the present invention provides a light-emitting device including a first luminescent material and a second luminescent material which emits visible light by irradiation with light from the first luminescent material, in which the second luminescent material contains at least a red phosphor which satisfies the following (A) and (C).

In another embodiment, the present invention provides a red phosphor containing a red phosphor which satisfies the following (A) and (C).

(A) An emission spectrum has at least one emission peak having a full width at half maximum (FWHM) of 20 nm or more and 65 nm or less, and

(C) Chromaticity coordinates of red light emitted by the red phosphor are within a region surrounded by four vertices, i.e., a point A (0.710, 0.290), a point B (0.650, 0.350), a point C (0.642, 0.350), and a point D (0.702, 0.290) based on coordinates represented by (x, y) in the CIE 1931 chromaticity coordinate system.

In one embodiment, a value of x+y in the chromaticity coordinates of the red light emitted by the red phosphor is generally 0.992 or more and 1.000 or less, and in another embodiment, may be greater than 0.992, 0.994 or more, 0.996 or more, and less than 1.000, or 0.999 or less.

In one embodiment, a value of y in the chromaticity coordinates of the red light emitted by the red phosphor is preferably 0.340 or less, more preferably 0.330 or less, still more preferably 0.320 or less, particularly preferably 0.310 or less, and even more preferably 0.300 or less. When the value of y in the chromaticity coordinates is equal to or less than the above upper limit, it is possible to provide a light-emitting device having favorable color rendering or color reproducibility in red, which is suitable for an image display device (display) application, for example.

The above embodiment can also be expressed as follows. That is, for example, in an embodiment in which the value of y is 0.340 or less, the chromaticity coordinates of the red light emitted by the red phosphor are within a region surrounded by four vertices, i.e., the point A (0.710, 0.290), a point E (0.660, 0.340), a point F (0.652, 0.340), and the point D (0.702, 0.290) based on the coordinates represented by (x, y) in the CIE 1931 chromaticity coordinate system. In an embodiment in which the upper limit value of y is changed, when the value of y at the point E and the point F is the upper limit value after the change, the value of x at the point E can be represented as [1 - upper limit value of y after change], and the value of x at the point F can be represented as [0.992 - upper limit value of y after change].

In another embodiment, the value of y in the chromaticity coordinates of the red light emitted by the red phosphor is preferably 0.295 or more, more preferably 0.300 or more, still more preferably 0.310 or more, and particularly preferably 0.315 or more. When the value of y in the chromaticity coordinates is equal to or greater than the above lower limit, it is possible to provide a light-emitting device having high relative visibility in a red region and favorable conversion efficiency, which is suitable for a lighting application, for example.

The above embodiment can also be expressed as follows. That is, for example, in an embodiment in which the value of y is 0.295 or more, the chromaticity coordinates of the red light emitted by the red phosphor are within a region surrounded by four vertices, i.e., a point G (0.705, 0.295), the point B (0.650, 0.350), the point C (0.642, 0.350), and a point H (0.697, 0.295) based on the coordinates represented by (x, y) in the CIE 1931 chromaticity coordinate system. In an embodiment in which the lower limit value of y is changed, when the value of y at the point G and the point H is the lower limit value after the change, the value of x at the point G can be represented as [1 - lower limit value of y after change], and the value of x at the point H can be represented as [0.992 - lower limit value of y after change].

In one embodiment, the red phosphor contained in the light-emitting device contains a phosphor which does not substantially include Mn, and in a specific embodiment, the red phosphor consists of only a phosphor which does not substantially include Mn.

When a part of or the entire red phosphor contained in the light-emitting device is a phosphor which does not substantially include Mn, that is, when the red phosphor includes a phosphor which does not substantially include Mn, a harmful Mn compound can be reduced in amount or eliminated, and a light-emitting device which is good for the human body and the environment can be provided.

Note that in the present description, a phosphor "which does not substantially include" a specific component means a phosphor which does not contain the specific component as elements constituting a composition of a crystal phase of the phosphor, and to which the specific component is not added as an additive element, an activator, or the like. The phosphor "which does not substantially include" a specific component allows a trace amount of the specific component to be unintentionally mixed in as an impurity and the like.

<Red Phosphor>

In one embodiment, the red phosphor includes at least a phosphor containing a crystal phase having a composition represented by the following formula [1].

$$Re_xMA_aMB_bMC_cN_dX_e \qquad [1]$$

(In formula [1], MA includes one or more elements selected from the group consisting of Sr, Ca, Ba, Na, K, Y, Gd, and La, MB includes one or more elements selected from the group consisting of Li, Mg, and Zn, MC includes one or more elements selected from the group consisting of Al, Si, Ga, In, and Sc, X includes one or more elements selected from the group consisting of F, Cl, Br, and I, Re includes one or more elements selected from the group consisting of Eu, Ce, Pr, Tb, and Dy, and a, b, c, d, e, and x respectively satisfy the following expressions.

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \le 0.2)$$

In formula [1], as Re, europium (Eu), cerium (Ce), praseodymium (Pr), neodymium (Nd), samarium (Sm), terbium (Tb), dysprosium (Dy), holmium (Ho), erbium (Er), thulium (Tm), ytterbium (Yb) or the like can be used. From the viewpoint of improving an emission wavelength and emission quantum efficiency, Re preferably includes one or more elements selected from the group consisting of Eu, Ce, Pr, Tb, and Dy, and more preferably includes Eu. Still more preferably, 80 mol% or more of Re is Eu, and even more preferably, Re is Eu.

In formula [1], MA includes one or more elements selected from the group consisting of calcium (Ca), strontium (Sr), barium (Ba), sodium (Na), potassium (K), yttrium (Y), gadolinium (Gd), and lanthanum (La), preferably includes one or more elements selected from the group consisting of Ca, Sr, and Ba, and more preferably includes Sr. Preferably, 80 mol% or more of MA consists of the above preferred elements, and more preferably, MA consists of the above preferred elements.

In formula [1], MB includes one or more elements selected from the group consisting of lithium (Li), magnesium (Mg), and zinc (Zn), and preferably includes Li. More preferably, 80 mol% or more of MB is Li, and still more preferably, MB is Li.

In formula [1], MC includes one or more elements selected from the group consisting of aluminum (Al), silicon (Si), gallium (Ga), indium (In), and scandium (Sc), preferably includes Al, Ga, or Si, and more preferably includes one or more elements selected from the group consisting of Al and Ga. Still more preferably, 80 mol% or more of MC consists of one or more elements selected from the group consisting of Al and Ga, particularly preferably, 90 mol% or more of MC consists of one or more elements selected from the group consisting of Al and Ga, and most preferably, MC consists of one or more elements selected from the group consisting of Al and Ga.

In one embodiment, 80 mol% or more of MC is Al, preferably 90 mol% or more, more preferably 95 mol% or more, and still more preferably 98 mol% or more of MC is Al. When 80 mol% or more of MC is Al, it is possible to provide a red phosphor which exhibits an emission peak wavelength and an emission intensity comparable to existing red phosphors such as S/CASN and which has a narrow spectral full width at half maximum, and a light-emitting device containing such a red phosphor has favorable color rendering or color reproducibility with maintaining conversion efficiency (Lm/W) comparable to or higher than that of a device in the related art.

In formula [1], N represents nitrogen. In order to maintain charge balance of the entire crystal phase or to adjust the emission peak wavelength, a part of N may be substituted with oxygen (O).

In formula [1], X includes one or more elements selected from the group consisting of fluorine (F), chlorine (Cl), bromine (Br), and iodine (I). That is, in a specific embodiment, from the viewpoint of stabilizing a crystal structure and maintaining the charge balance of the phosphor as a whole, N may be partially substituted with the halogen element represented by X.

In formula [1], a case where trace amounts of components other than those specified are unavoidably or unintentionally contained is included.

Examples of the components other than those specified include an element whose element number differs by one from the artificially added element, an element of the same group as the artificially added element, a rare earth element which is different from an artificially added rare earth element, a halogen element with use of halides as raw materials, and other elements which can generally be contained as impurities in various raw materials.

In the present description, "artificially adding" a specific component means intentionally adding a specific component as an element constituting the composition of the crystal phase of the phosphor, and a case where a trace amount of a specific component is unintentionally mixed in as an impurity and the like does not fall under the category of "artificially adding". A phosphor to which a specific component is artificially added can be said to substantially contain the specific component.

Components other than those specified may be unavoidably or unintentionally contained, for example, when derived from impurities in raw materials, or when introduced during production processes such as a pulverization step and a synthesis step. In addition, examples of the components added in a trace amount include a reaction aid and raw materials.

In formula [1], a, b, c, d, e, and x indicate molar contents of MA, MB, MC, N, X, and Re contained in the phosphor, respectively.

The value of a is generally 0.6 or more, preferably 0.7 or more, more preferably 0.8 or more, and still more preferably 0.9 or more, and is generally 1.4 or less, preferably 1.3 or less, more preferably 1.2 or less, and still more preferably 1.1 or less.

The value of b is generally 0.6 or more, preferably 0.7 or more, more preferably 0.8 or more, and still more preferably 0.9 or more, and is generally 1.4 or less, preferably 1.3 or less, more preferably 1.2 or less, and still more preferably 1.1 or less.

The value of c is generally 2.1 or more, preferably 2.4 or more, more preferably 2.6 or more, and still more preferably 2.8 or more, and is generally 3.9 or less, preferably 3.6 or less, more preferably 3.4 or less, and still more preferably 3.2 or less.

The value of d is generally 3 or more, preferably 3.2 or more, more preferably 3.4 or more, still more preferably 3.6 or more, and even more preferably 3.8 or more, and is generally 5 or less, preferably 4.8 or less, more preferably 4.6 or less, still more preferably 4.4 or less, and even more preferably 4.2 or less.

The value of e is not particularly limited and is generally 0 or more, and generally 0.2 or less, preferably 0.1 or less, more preferably 0.06 or less, still more preferably 0.04 or less, and even more preferably 0.02 or less.

The value of x is generally greater than 0, preferably 0.0001 or more, and more preferably 0.001 or more, and is generally 0.2 or less, preferably 0.15 or less, more preferably 0.12 or less, still more preferably 0.1 or less, and even more preferably 0.08 or less. When the value of x is a value equal to or greater than the above lower limit or greater than the above lower limit, it is possible to obtain a phosphor having a favorable emission intensity, and when the value of x is equal to or less than the above upper limit, it is possible to obtain a phosphor which contains a crystal in which Re is incorporated favorably and Re easily functions as an emission center. When such a red phosphor is contained, a light-emitting device having favorable conversion efficiency can be provided.

When b, c, d, and e are within the above ranges, the crystal structure is stabilized. In addition, the values of d and e can be appropriately adjusted for the purpose of maintaining the charge balance of the entire phosphor.

When the value of a is within the above range, the crystal structure is stabilized and a phosphor having few heterogeneous phases can be obtained. When such a red phosphor is contained, it is possible to provide a light-emitting device having favorable absorption efficiency for excitation light, and a favorable conversion efficiency of red color and overall.

The value of b+c is generally 3.1 or more, preferably 3.4 or more, and more preferably 3.7 or more, and is generally 4.9 or less, preferably 4.6 or less, and more preferably 4.3 or less.

When the value of b+c is within the above range, the crystal structure is stabilized.

The value of d+e is generally 3.2 or more, preferably 3.4 or more, and more preferably 3.7 or more, and is generally 5.0 or less, preferably 4.6 or less, and more preferably 4.3 or less.

When the value of d+e is within the above range, the crystal structure is stabilized.

It is preferable that any value is within the above range since the obtained red phosphor has a favorable emission peak wavelength and a favorable full width at half maximum in the emission spectrum.

Note that a method for identifying the elemental composition of the red phosphor is not particularly limited, and the elemental composition can be determined by a well-known method, for example, GD-MS, ICP spectroscopy, energy dispersive X-ray spectrometry (EDX), or the like.

In one embodiment, the red phosphor includes at least a phosphor containing a crystal phase having a composition represented by the following formula [2].

$$Re_xMA_aMB_b(MC'_{1-y}MD_y)_cN_dX_e \qquad [2]$$

In formula [2], MA includes one or more elements selected from the group consisting of Sr, Ca, Ba, Na, K, Y, Gd, and La, MB includes one or more elements selected from the group consisting of Li, Mg, and Zn, MC' is Al, MD includes one or more elements selected from the group consisting of Si, Ga, In, and Sc, X includes one or more elements selected from the group consisting of F, Cl, Br, and I, Re includes one or more elements selected from the group consisting of Eu, Ce, Pr, Tb, and Dy, and a, b, c, d, e, x, and y respectively satisfy the following expressions.

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0)$$

The types and structures of MA, MB, N, X, and Re elements in formula [2] above can be the same as in formula [1] above.

MC' is Al.

MD includes one or more elements selected from the group consisting of Si, Ga, In, and Sc, preferably includes one or more elements selected from the group consisting of Ga and Si from the viewpoint of improving crystal stability and the emission intensity, and more preferably includes Ga.

In a still more preferred specific embodiment, 80 mol% or more of MD is Ga, and MD may consist of Ga.

The values and preferred ranges of a, b, c, d, e, and x in formula [2] can be the same as in formula [1].

The value of y in formula [2] is greater than 0.0, generally 0.01 or more, preferably 0.015 or more, more preferably 0.03 or more, still more preferably 0.05 or more, and particularly preferably 0.10 or more, and is generally 1.00 or less, preferably 0.70 or less, more preferably 0.50 or less, still more preferably 0.30 or less, and particularly preferably 0.25 or less.

When the value of y is equal to or greater than the above lower limit, the emission peak wavelength of the phosphor becomes shorter, and when such a red phosphor is used, a light-emitting device having favorable color rendering or color reproducibility can be provided. In addition, when the value of y is equal to or less than the above upper limit, a phosphor having a favorable emission intensity can be obtained, and when such a red phosphor is used, a light-emitting device having favorable conversion efficiency can be provided. In order to obtain a preferred emission intensity and emission peak wavelength depending on the purpose, the value of y can be adjusted as appropriate.

In formula [1] or formula [2], when a part of N is replaced with oxygen (O), formula [1] may be represented as the following formula [3], and formula [2] may be represented as the following formula [4].

$$Re_xMA_aMB_bMC_c(N,O)_dX_e \qquad [3]$$

$$Re_xMA_aMB_b(MC'_{1-y}MD_y)_c(N,O)_dX_e \qquad [4]$$

Note that in formula [3] and formula [4], (N,O) means containing N and O, and Re, MA, MB, MC, MC', MD, X, x, y, a, b, c, d, and e are all the same as those in formula [1] or formula [2].

A proportion of N (nitrogen) in the (N,O) site can be freely adjusted, and is preferably 50 mol% or more, more preferably 70 mol% or more, and still more preferably 80 mol% or more. By appropriately adjusting the proportion of N (nitrogen) in (N,O), the charge balance of the entire crystal phase can be maintained or the emission peak wavelength can be adjusted.

In addition, in the present description, all descriptions regarding formula [1] or formula [2] can also be applied to formula [3] or formula [4].

[Particle Size of Crystal Phase]

A particle size of the crystal phase of the red phosphor according to the present embodiment is generally 2 $\mu$m or more and 40 $\mu$m or less in terms of a volume-based median particle size (volume median particle size). The lower limit value is preferably 3 $\mu$m, more preferably 4 $\mu$m, and still more preferably 5 $\mu$m, and the upper limit value is preferably 35 $\mu$m, more preferably 30 $\mu$m, still more preferably 25 $\mu$m, and particularly preferably 20 $\mu$m.

It is preferable that the volume-based median particle size (volume median particle size) is equal to or greater than the above lower limit from the viewpoint of improving light emission characteristics exhibited by the crystal phase in an LED package, and it is preferable that the volume-based median particle size (volume median particle size) is equal to or less than the above upper limit since the crystal phase can avoid clogging of nozzles in a production process for the LED package.

The volume-based median particle size (volume median particle size) of the crystal phase of the phosphor can be measured by measurement techniques well known to those skilled in the art, and can be measured, for example, by a laser granulometer in a preferred embodiment. In Examples in the present description, the volume-based median particle size (volume median particle size, $d_{50}$) is defined as a particle size at which the volume-based relative particle amount is 50% when a sample is measured using a particle size distribution analyzer based on the principle of laser diffraction/scattering, and a particle size distribution (cumulative distribution) is determined.

{Physical properties, etc. of Red Phosphor}

[Space Group]

A crystal system (space group) in the red phosphor according to the present embodiment is not limited as long as the effects of the present invention can be obtained, and is preferably P-1 in a specific embodiment. The space group in the red phosphor according to the present embodiment is not particularly limited if an average structure statistically considered within a distinguishable range by powder X-ray diffraction or single crystal X-ray diffraction shows a repeating period having the above length, and preferably belongs to No. 2 based on "International Tables for Crystallography (Third, revised edition), Volume A SPACE-GROUP SYMMETRY".

By being in the above space group, a red phosphor having a narrow full width at half maximum (FWHM) in the emission spectrum and favorable emission efficiency can be obtained.

Here, the space group can be determined according to a well-known method, for example, by electron beam diffraction, X-ray diffraction structure analysis using a powder or a single crystal, and neutron beam diffraction structure analysis.

In a specific embodiment, when, in a powder X-ray diffraction spectrum of the red phosphor according to the present embodiment, an intensity of a peak appearing in a region of $2\theta = 38$ to $39$ degree is $I_x$, an intensity of a peak appearing in a region of $2\theta = 37$ to $38$ degree is $I_y$, $I_x/I_y$, which is a relative intensity of $I_x$ when $I_y$ is 1, is preferably 0.140 or less, more preferably 0.120 or less, still more preferably 0.110 or less, even more preferably 0.080 or less, particularly preferably 0.060 or less, and especially preferably 0.040 or less, and is generally 0 or more, and the smaller, the better.

The peak in the region of $2\theta = 37$ to $38$ degree is one of characteristic peaks of a main phase of the red phosphor according to the present embodiment, and the relatively high $I_y$ makes it possible to obtain a red phosphor having a higher phase purity. When $I_x/I_y$ is equal to or less than the above upper limit, a phosphor having a high phase purity and a narrow full width at half maximum (FWHM) in the emission spectrum can be obtained, so that the emission efficiency of the light-emitting device is improved.

[Internal Quantum Efficiency of Red Phosphor]

In one embodiment, internal quantum efficiency of the red phosphor is 30% or more. The internal quantum efficiency is preferably 35% or more, more preferably 40% or more, still more preferably 45% or more, particularly preferably 50% or more, and especially preferably 55% or more. The upper limit thereof is not limited and is preferably higher, and it is generally 100% or less.

The internal quantum efficiency of the red phosphor can be determined by a well-known method, and can be calculated from, for example, an emission spectrum measured using a spectrophotometer.

[Characteristics of Emission Spectrum]

The red phosphor according to the present embodiment is excited by irradiation with light having an appropriate wavelength, and emits red light exhibiting a favorable emission peak wavelength in the emission spectrum and a favorable full width at half maximum (FWHM) in the emission spectrum. Hereinafter, the emission spectrum, the excitation wavelength, the emission peak wavelength, and the full width at half maximum (FWHM) in the emission spectrum will be described.

(Excitation Wavelength)

The red phosphor according to the present embodiment has an excitation peak in a wavelength range of generally 270 nm or more, preferably 300 nm or more, more preferably 320 nm or more, still more preferably 350 nm or more, and particularly preferably 400 nm or more, and of generally 550 nm or less, preferably 520 nm or less, and more preferably 500 nm or less. That is, it is excited by light in a near-ultraviolet to blue region.

Note that the description of the shape of the emission spectrum, and the emission peak wavelength and the full width at half maximum in the emission spectrum below are applicable regardless of the excitation wavelength. From the viewpoint of improving the quantum efficiency, it is preferable to emit light having a wavelength in the above range with favorable absorption and excitation efficiency.

(Emission Peak Wavelength)

In one embodiment, the emission spectrum of the red phosphor generally has at least one emission peak having an emission peak wavelength of 620 nm or more and 660 nm or less.

In a specific embodiment, the emission spectrum of the red phosphor has at least one emission peak at preferably 625 nm or more, more preferably 630 nm or more, still more preferably 635 nm or more, even more preferably 640 nm or more, and extremely preferably 645 nm or more. A light-emitting device containing the red phosphor having the at least one emission peak having an emission peak wavelength equal to or greater than the above lower limit has favorable red color rendering or red color reproducibility, and is suitable for applications such as a backlight for an image display device (display). Alternatively, the light-emitting device can emit clear red light, which is suitable for applications such as a brake lamp.

In another specific embodiment, the emission spectrum has at least one emission peak at preferably 655 nm or less, more preferably 650 nm or less, still more preferably 648 nm or less, even more preferably 645 nm or less, particularly preferably 640 nm or less, and extremely preferably 637 nm or less. A red phosphor having the at least one emission peak in the emission spectrum equal to or less than the above upper limit has a low emission intensity in a wavelength region around 700 nm, where the relative visibility is low, and a light-emitting device containing such red phosphor has favorable conversion efficiency and is suitable for, for example, an illumination device application.

The method of adjusting the emission peak wavelength is not particularly limited. For example, by adjusting the configuration of the MC element, the emission peak wavelength can be adjusted with keeping the full width at half maximum in the emission spectrum narrow. In a specific embodiment, the emission peak wavelength can be adjusted to a long wavelength side by increasing the proportion of Al in MC, and the emission peak wavelength can be adjusted to a short wavelength side by increasing the proportion of an element other than Al in a part of MC in formula [1] or the MD element in formula [2].

(Full width at half maximum in Emission Spectrum)

The red phosphor according to the present embodiment has a full width at half maximum in the emission spectrum of generally 70 nm or less, preferably 65 nm or less, more preferably 60 nm or less, still more preferably 57 nm or less, particularly preferably 55 nm or less, and most preferably 50 nm or less, and of generally 10 nm or more.

When a red phosphor having a full width at half maximum in the emission spectrum within the above range is used, a color reproduction range can be widened without reducing a color purity in an image display device such as a liquid crystal display.

In addition, when the emission peak wavelength and the full width at half maximum in the emission spectrum are equal to or less than the above upper limits, a red phosphor having relatively high visibility in the emission wavelength region can be provided, and when such a red phosphor is used in a light-emitting device, a light-emitting device having high conversion efficiency can be provided.

Note that in order to excite the red phosphor with light having a wavelength of about 450 nm, a GaN-based LED can be used, for example. In addition, measurement of the emission spectrum, and calculation of the emission peak wavelength, the peak relative intensity, and the full width at half maximum in the emission spectrum of the red phosphor can be performed using, for example, a commercially available spectrum measuring device, such as a phosphorescence measuring device equipped with a light source having an emission wavelength of 300 nm to 400 nm, such as a commercially available xenon lamp, and a general photodetector.

In one embodiment, the red phosphor in the light-emitting device has an emission peak wavelength x (nm) and a full width at half maximum y (nm) in the emission spectrum satisfying a relationship: $y \leq 184-0.2x$.

When a phosphor having the emission peak wavelength and the full width at half maximum of the phosphor satisfying the above expression is used, the conversion efficiency of the light-emitting device can be improved.

<Method for Producing Phosphor>

The phosphor according to the present embodiment can be synthesized by mixing raw materials of respective elements constituting the phosphor such that the proportions of respective elements satisfy formula [1] or formula [2], followed by heating.

[Phosphor Raw Material]

Phosphor raw materials to be supply sources of respective elements (MA, MB, MC, MC', and Re) are not particularly limited. Examples thereof include single substances, oxides, nitrides, hydroxides, halides such as chlorides and fluorides, inorganic salts such as sulfates, nitrates and phosphates, and organic acid salts such as acetates of respective elements. In addition, a compound containing two or more in the above element group may be used. In addition, each compound may be a hydrate or the like.

Note that in Examples to be described below, a nitride was used for each element other than Re, and a fluoride or an oxide were used for the Re element as raw materials for the phosphor.

The method of obtaining each raw material for a phosphor is not particularly limited, and commercially available materials can be purchased and used.

The purity of each raw material for phosphor is not particularly limited, and is preferably high from the viewpoint of setting a strict element ratio and from the viewpoint of avoiding the appearance of heterogeneous phases due to impurities. The purity is generally 90 mol% or more, preferably 95 mol% or more, more preferably 97 mol% or more, and still more preferably 99 mol% or more. The upper limit thereof is not particularly limited, and is generally 100 mol% or less, and unavoidable impurities may be contained.

In Examples to be described below, in all cases, a raw material for a phosphor having a purity of 95 mol% or more was used.

The oxygen element (O), the nitrogen element (N), and the halogen element (X) can be supplied by using oxides, nitrides, halides, and the like as the raw materials for a phosphor which are supply sources for the above elements, and can be contained as appropriate by using an oxygen- or nitrogen-containing atmosphere during a synthesis reaction.

[Mixing Step]

The method of mixing the raw materials for a phosphor is not particularly limited, and a well-known method can be used. For example, the raw materials for a phosphor are weighed so as to obtain a desired composition, and sufficiently mixed using a ball mill or the like to obtain a mixture of the raw materials for a phosphor. The above mixing method is not particularly limited, and specific examples include the following methods (a) and (b).

(a) A dry mixing method of pulverizing and mixing the raw materials for a phosphor by combining pulverization using, for example, a dry pulverizer such as a hammer mill, a roll mill, a ball mill, and a jet mill, or a mortar and a pestle with mixing using, for example, a mixer such as a ribbon blender, a V type blender, and a Henschel mixer, or a mortar and a pestle.
(b) A wet mixing method of adding a solvent or a dispersion medium such as water to the raw materials for a phosphor, performing mixing using, for example, a pulverizer, a mortar and a pestle, or an evaporating dish and a stirring rod to bring the mixture to a solution or slurry state, and then performing drying by spray drying, heat drying, or natural drying.

The raw materials for a phosphor may be mixed by either the dry mixing method or the wet mixing method. In order to avoid contamination of the raw materials for a phosphor with moisture, a dry mixing method or a wet mixing method using a water-insoluble solvent is preferred.

Note that in Examples to be described below, the method (a) was used.

[Heating Step]

In the heating step (hereinafter sometimes referred to as a firing step), for example, a mixture of the raw materials for a phosphor obtained in the mixing step is charged into a crucible, and subsequently heated at a temperature of from 500°C to 1200°C. The temperature in the heating step is preferably 600°C or higher, and more preferably 700°C or higher, and is preferably 1000°C or lower, more preferably 950°C or lower, and may be 900°C or lower.

When the heating temperature (hereinafter sometimes referred to as a firing temperature) is made to be a low temperature, particularly 950°C or lower, a phosphor having a composition represented by formula [1] with a high phase purity and a high emission intensity can be obtained. The reason is that at a high temperature such as 1000°C or higher or 1100°C or higher, substances containing Li, Mg, Na, etc. having a high vapor pressure tend to volatilize, and the ratio of each element in the synthesis reaction for the phosphor tends to fluctuate, and on the other hand, by performing synthesis at a low temperature such as 950°C or lower, there is a possibility that the fluctuation in the ratio of each element can be prevented.

In addition, the pressure in the heating step may a normal pressure or pressurization as long as the desired phosphor is obtained, and pressurization is preferred in order to prevent volatilization of elements contained in the raw materials for a phosphor. In the case of pressurization, the pressure is generally 0.1 MPa or more and 200 MPa or less, and preferably 100 MPa or less. When the pressure is within the above range, favorable reactivity of the raw materials for a phosphor can be ensured.

The pressurization method is not limited, and for example, a method of heating a sealed container, a mechanical pressurization method, or a method of using a gas pressure can be used.

The material of the crucible is preferably one which does not react with the raw materials for a phosphor or reactants, and examples thereof include ceramics such as alumina, quartz, boron nitride, silicon carbide, and silicon nitride, metals such as nickel (Ni), platinum (Pt), molybdenum (Mo), tungsten (W), tantalum (Ta), niobium (Nb), iridium (Ir), and rhodium (Rh), or an alloy containing these as a main component.

The heating is preferably performed under an inert atmosphere, and a gas containing nitrogen, argon, helium, or the like as a main component can be used.

Note that in Examples to be described below, the heating was performed under a nitrogen atmosphere.

In the heating step, the heating is performed in the above temperature range for generally from 10 minutes to 200 hours, preferably from 1 hour to 100 hours, and more preferably from 2 hours to 50 hours. In addition, such a heating step may be performed once, or may be performed a plurality of times. Examples of an aspect in which the heating step is performed a plurality of times include an aspect including an annealing step of performing heating under a pressure to repair defects, and an aspect of primary heating for obtaining primary particles or intermediates and then performing secondary heating for obtaining secondary particles or a final product.

Accordingly, the phosphor according to the present embodiment is obtained.

<Light-emitting Device>

In one embodiment, the present invention provides a light-emitting device including a first luminescent material and a second luminescent material which emits visible light by irradiation with light from the first luminescent material, in which

the second luminescent material contains at least a red phosphor which satisfies the following (A) and (B):

(A) An emission spectrum has at least one emission peak having a full width at half maximum (FWHM) of 20 nm or more and 65 nm or less, and

(B) a chromaticity coordinate of a light emission color is present between two straight lines represented by the following equation (a) and equation (b) based on a CIE 1931 chromaticity coordinate system:

$$y = 0.992\text{-}x \qquad (a),$$

$$y = 1.000\text{-}x \qquad (b),$$

and

$$0.290 \le y \le 0.350.$$

In another embodiment, the present invention provides a light-emitting device in which the second luminescent material contains at least a red phosphor containing a crystal phase having a composition represented by the formula [1] or formula [2] above. Here, as the second luminescent material, one type of phosphor may be used alone, or two or more types of phosphors may be used in combination in any combination and ratio.

In the light-emitting device according to the present embodiment, the second luminescent material contains the red phosphor which satisfies at least the above (A) and (B), and can further contain a yellow phosphor which emits yellow phosphorescence, a green phosphor which emits green phosphorescence, or a red phosphor which emits (orange or red) phosphorescence in a red region (a red phosphor which does not satisfy at least one of the above (A) and (B)) under irradiation of light from an excitation light source.

In addition, in a specific embodiment, the light-emitting device according to the present invention is a light-emitting device in which the second luminescent material further contains a yellow phosphor and/or a green phosphor.

Specifically, in a case of configuring the light-emitting device, the yellow phosphor preferably has an emission peak in a wavelength range of 550 nm or more and 600 nm or less, and the green phosphor preferably has an emission peak in a wavelength range of 500 nm or more and 560 nm or less. In addition, the orange or red phosphor has an emission peak in a wavelength range of generally 615 nm or more, preferably 620 nm or more, more preferably 625 nm or more, and still more preferably 630 nm or more, and of generally 660 nm or less, preferably 650 nm or less, more preferably 645 nm or less, and still more preferably 640 nm or less.

When the phosphors in the above wavelength regions are appropriately combined, a light-emitting device exhibiting excellent color reproducibility can be provided. Note that as for the excitation light source, one having an emission peak in a wavelength range of less than 420 nm may be used.

Hereinafter, an aspect of a light-emitting device using a phosphor which satisfies at least the above (A) and (B) as the red phosphor will be described, but the present embodiment is not limited thereto.

In the above case, the light-emitting device according to the present embodiment can be, for example, in the following (X), (Y) or (Z) aspects.

(X) An aspect in which a first luminescent material and a second luminescent material are included, and the second luminescent material contains a red phosphor which satisfies at least the above (A) and (B) and further contains at least one phosphor (yellow phosphor) having an emission peak in a wavelength range of 550 nm or more and 600 nm or less.

(Y) An aspect in which a first luminescent material and a second luminescent material are included, and the second luminescent material contains a red phosphor which satisfies at least the above (A) and (B) and further contains at least one phosphor (green phosphor) having an emission peak in a wavelength range of 500 nm or more and 560 nm or less.

(Z) An aspect in which a first luminescent material and a second luminescent material are included, and the second luminescent material contains a red phosphor which satisfies at least the above (A) and (B), and further contains at least one phosphor (yellow phosphor) having an emission peak in a wavelength range of 550 nm or more and 600 nm or less, and at least one phosphor (green phosphor) having an emission peak in a wavelength range of 500 nm or more and 560 nm or less.

As the yellow phosphor and/or the green phosphor in the above aspects, commercially available ones can be used. For example, a garnet type phosphor, a silicate type phosphor, a nitride phosphor, or an oxynitride phosphor can be used. In a specific embodiment, the yellow phosphor and/or the green phosphor include any one or more of a garnet type phosphor, a silicate type phosphor, a nitride phosphor, and an oxynitride phosphor.

(Yellow Phosphor)

Examples of the garnet type phosphor which can be used in the yellow phosphor include $(Y, Gd, Lu, Tb, La)_3(Al, Ga)_5O_{12}:(Ce, Eu, Nd)$. Examples of the silicate type phosphor which can be used in the yellow phosphor include $(Ba, Sr, Ca, Mg)_2SiO_4:(Eu, Ce)$. Examples of the nitride phosphor and the oxynitride phosphor which can be used in the yellow phosphor include $(Ba, Ca, Mg)Si_2O_2N_2:Eu$ (SION-based phosphor), $(Li, Ca)_2(Si, Al)_{12}(O, N)_{16}:(Ce, Eu)$ (a-sialon phosphor), $(Ca, Sr)AlSi_4(O, N)_7:(Ce, Eu)$ (1147 phosphor), and $(La, Ca, Y, Gd)_3(Al, Si)_6N_{11}:(Ce, Eu)$ (LSN phosphor).

These may be used alone or in combination of two or more kinds thereof.

Among the above phosphors, the yellow phosphor is preferably a garnet type phosphor, and most preferably a YAG-based phosphor represented by $Y_3Al_5O_{12}:Ce$.

(Green Phosphor)

Examples of the garnet type phosphor which can be used in the green phosphor include $(Y, Gd, Lu, Tb, La)_3(Al, Ga)_5O_{12}:(Ce, Eu, Nd)$ and $Ca_3(Sc, Mg)_2Si_3O_{12}:(Ce, Eu)$ (CSMS phosphor). Examples of the silicate type phosphor which can be used in the green phosphor include $(Ba, Sr, Ca, Mg)_3SiO_{10}:(Eu, Ce)$ and $(Ba, Sr, Ca, Mg)_2SiO_4:(Ce, Eu)$ (BSS phosphor). Examples of the oxide phosphor which can be used in the green phosphor include $(Ca, Sr, Ba, Mg)(Sc, Zn)_2O_4:(Ce, Eu)$ (CASO phosphor). Examples of the nitride phosphor and the oxynitride phosphor which can be used in the green phosphor include $(Ba, Sr, Ca, Mg)Si_2O_2N_2:(Eu, Ce)$, $Si_{6-z}Al_zO_zN_{8-z}:(Eu, Ce)$ (β-sialon phosphor) $(0 < z \leq 1)$, $(Ba, Sr, Ca, Mg, La)_3(Si, Al)_6O_{12}N_2:(Eu, Ce)$ (BSON phosphor), and $(La, Ca, Y, Gd)_3(Al, Si)_6N_{11}:(Ce, Eu)$ (LSN phosphor).

These may be used alone or in combination of two or more kinds thereof.

(Red Phosphor)

As the red phosphor, the phosphor according to the present embodiment which satisfies at least the above (A) and (B) is used. In addition to the phosphor according to the present embodiment, other orange to red phosphors can be used, for example, a garnet type phosphor, a sulfide phosphor, a nanoparticle phosphor, a nitride phosphor, and an oxynitride phosphor can be used. As other orange to red phosphors, for example, the following phosphors can be used.

Examples of the sulfide phosphor include $(Sr, Ca)S:Eu$ (CAS phosphor) and $La_2O_2S:Eu$ (LOS phosphor). Examples of the garnet type phosphor include $(Y, Lu, Gd, Tb)_3Mg_2AlSi_2O_{12}:Ce$. Examples of the nanoparticles include CdSe. Examples of the nitride or oxynitride phosphor include $(Sr, Ca)AlSiN_3:Eu$ (S/CASN phosphor), $(CaAlSiN_3)_{1-x} \cdot (SiO_2N_2)_x:Eu$ (CASON phosphor), $(La, Ca)_3(Al, Si)_6N_{11}:Eu$ (LSN phosphor), $(Ca, Sr, Ba)_2Si_5(N,O)_8:Eu$ (258 phosphor), $(Sr, Ca)Al_{1+x}Si_{4-x}O_xN_{7-x}:Eu$ (1147 phosphor), $M_x(Si, Al)_{12}(O, N)_{16}:Eu$ (M is Ca, Sr, or the like) (a-sialon phosphor), and $Li(Sr, Ba)Al_3N_4:Eu$ (all x above is $0 < x < 1$).

These may be used alone or in combination of two or more kinds thereof.

[Configuration of Light-emitting Device]

The light-emitting device according to the present embodiment includes a first luminescent material (excitation light source), and as a second luminescent material, a red phosphor which satisfies at least the above (A) and (B) can be used. A configuration of the light-emitting device is not limited, and any known device configuration can be used.

As the first luminescent material, an LED element having a light-emitting structure made of various semiconductors such as a GaN-based semiconductor, a ZnO-based semiconductor, and a SiC-based semiconductor can be used.

Examples of the device configuration and embodiments of the light-emitting device include those described in JP2007-291352A, for example.

In addition, the LED element may be fixed in a package such as a cannonball-type package or an SMD-type package, or directly fixed on a circuit board as in the case of a chip-on-board type light-emitting device. The form of optical coupling between the LED element and the phosphor is not particularly limited, and a space therebetween may simply be filled with a transparent medium (including air), or an optical element such as a lens, an optical fiber, a light guide plate, or a reflecting mirror may be interposed therebetween. A structure in which phosphor particles are dispersed in a translucent matrix is typically formed by curing a resin paste in which particulate phosphors are dispersed. In addition to a structure in which such cured product of paste is embedded into an LED element, various structures can be used, such as a structure in which such cured product covers a part of the surface of the LED element in a film form, and a structure in which a film made of such a cured product is disposed at a location away from the LED element.

{Application of Light-emitting Device}

Applications of the light-emitting device are not particularly limited, and the light-emitting device can be used in various fields where a general light-emitting device is used. A light-emitting device having high color rendering can be particularly suitably used as a light source for an illumination device or an image display device.

In addition, a light-emitting device containing a red phosphor having a favorable emission wavelength can also be used in a red indicator lamp for a vehicle, or in a white light indicator lamp for a vehicle that includes the red.

[Illumination Device]

In one embodiment, the present invention can provide an illumination device including the light-emitting device as a light source.

When the light-emitting device is applied to an illumination device, a specific configuration of the illumination device is not limited, and a light-emitting device such as those described above may be appropriately incorporated into a known illumination device and used. Examples thereof include a plane emission illumination device in which many light-emitting devices are lined up on a bottom surface of a holding case.

[Image Display Device]

In one embodiment, the present invention can provide an image display device including the light-emitting device as a light source.

When the light-emitting device is used as a light source of an image display device, the specific configuration of the image display device is not limited, and it is preferable that a color filter is used together. For example, in a case of forming a color image display device using a color liquid crystal display element as the image display device, an image display device can be formed by setting the light-emitting device as a back light, and combining an optical shutter using a liquid crystal with a color filter having red, green, and blue pixels.

[Indicator Lamp for Vehicle]

In one embodiment, the present invention can provide an indicator lamp for a vehicle including the light-emitting device as a light source.

In a specific embodiment, a light-emitting device used in an indicator lamp for a vehicle is preferably a light-emitting device radiating white light. In the light-emitting device radiating white light, light radiated from the light-emitting device preferably has a deviation duv (also known as "Δuv") from the blackbody radiation locus of a light color of from -0.0200 to 0.0200 and a color temperature of 5000 K or higher and 30000 K or lower.

In a specific embodiment, a light-emitting device used in an indicator lamp for a vehicle is preferably a light-emitting device radiating red light. In this embodiment, for example, the light-emitting device may absorb blue light emitted from a blue LED chip and emit red to form a red light indicator lamp for a vehicle.

The indicator lamp for a vehicle includes illumination provided to a vehicle for the purpose of providing another vehicle, a person, or the like with some sort of indication, such as a head lamp, a side lamp, a back lamp, a blinker, a brake lamp, or a fog lamp of a vehicle.

Examples

Hereinafter, some specific embodiments of the present invention will be described with reference to Examples, but the present invention is not limited to the following unless it departs from the gist thereof.

{Measurement Method}

[Measurement of Emission Spectrum]

The emission spectrum was measured using a fluorescence spectrophotometer FP8500 (manufactured by JASCO Corporation) under the following measurement conditions.

·Light source: xenon lamp
·Excitation wavelength: 455 nm
·Measurement wavelength range: 380 nm to 780 nm
·Measurement interval: 1.0 nm

The values of the chromaticity coordinates were calculated based on emission spectrum data from 480 nm to 780 nm using a CIE 1931 XYZ color matching functions.

[Measurement of Quantum Efficiency]

The quantum efficiency was calculated based on the emission spectrum measured using a fluorescence spectrophotometer FP8500 (manufactured by JASCO Corporation) under the following measurement conditions.

·Light source: xenon lamp
·Excitation wavelength: 455 nm
·Measurement wavelength range: 380 nm to 780 nm
·Measurement interval: 1.0 nm

[Phosphor Blending Simulation]

A white spectrum satisfying a specific chromaticity coordinate point by combination of a spectrum of a blue LED chip emitting light at 449 nm with any phosphor was created based on information on an excitation emission spectrum, internal quantum efficiency, and absorption efficiency of excitation light of each phosphor measured, and a simulation was conducted to estimate a phosphor blending ratio at this time.
Based on the obtained white spectrum, spectral efficiency (LER), i.e., a luminous flux (Lm) per energy (Wopt) of the emission spectrum, and a color rendering index of R1 to R15 were calculated.

<Production of Phosphor>

[Phosphor 1]

An exemplary red phosphor used in a light-emitting device according to an embodiment of the present invention or a comparative example was produced.
With reference to JP2017-008130A and Chemistry of Materials 2019 31 (12), 4614-4618, or the like, nitrides of respective elements were mixed such that the ratio of Sr:Li:Al was approximately 1:1:3, the mixture was charged into a boron nitride crucible, and the container was sealed, followed by heating at 1000°C for 5 hours under a nitrogen gas atmosphere, to give a phosphor 1.

[Phosphors 2 to 9]

Phosphors 2 to 9 were obtained in the same manner as the phosphor 1, except that a nitride raw material containing Ga was appropriately used such that compositions of the phosphors were the compositions as shown in Table 1, and the firing temperature was set to 845°C.

[Phosphor 10]

A phosphor 10 was obtained in the same manner as the phosphor 1, except that a nitride raw material containing Ga was used such that a composition of the phosphor was the composition as shown in Table 1, and the firing temperature was set to 1020°C. Table 1 shows characteristics of the phosphors 1 to 10. Note that in Table 1, the relative emission intensity is a relative value when the emission intensity of the phosphor 1 is set to 1.

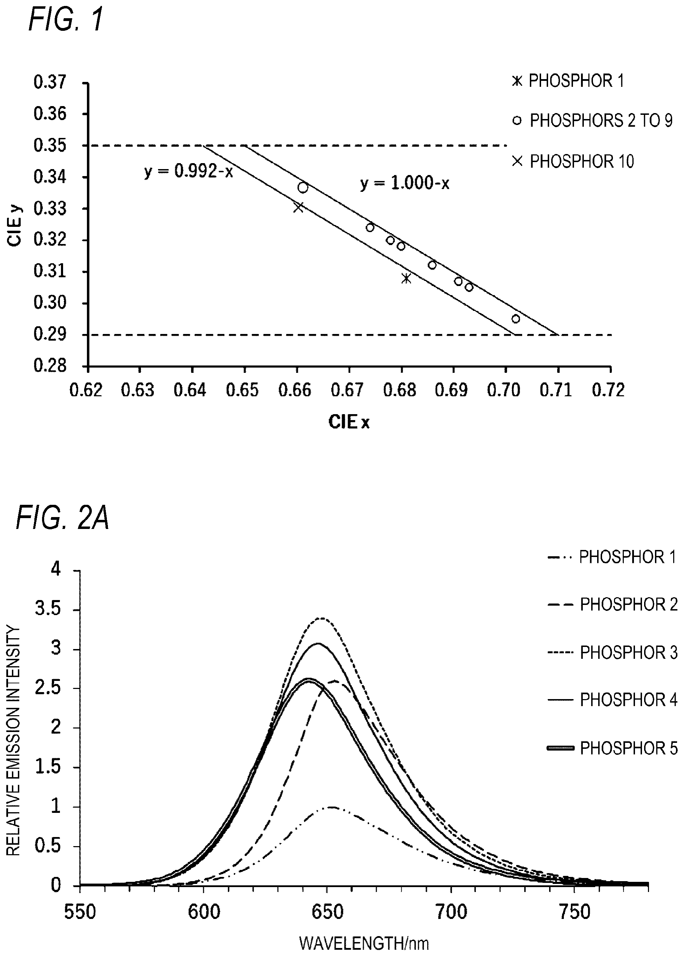

Fig. 1 shows a plot of light emission colors of samples, i.e., the phosphors 1 to 10 based on the coordinates represented by (x, y) in the CIE chromaticity coordinates.
It can be seen that the phosphors 1 and 10 are red phosphors which do not satisfy the above (B) at a point where the CIE chromaticity coordinates are not present between the two straight lines represented by the equation (a) and the equation (b). On the other hand, it can be seen that the phosphors 2 to 9 are red phosphors which satisfy the above (A) and (B).

Table 1

| | Composition | Eu/[Eu+Sr] | EQE | iQE | Relative emission intensity | Emission peak wavelength/ nm | FWHM /nm | CIE x | CIE y | x+y |
|---|---|---|---|---|---|---|---|---|---|---|
| Phosphor 1 | $SrLiAl_3N_4$:Eu | 0.01 | 15% | 36% | 1 | 652 | 53 | 0.681 | 0.308 | 0.989 |
| Phosphor 2 | $SrLiAd_3N_4$:Eu | 0.01 | 35% | 53% | 2.57 | 654 | 50 | 0.702 | 0.295 | 0.997 |
| Phosphor 3 | $SrLiAl_{2.4}Ga_{0.6}N_4$:Eu | 0.01 | 44% | 62% | 3.34 | 648 | 53 | 0.693 | 0.305 | 0.998 |
| Phosphor 4 | $SrLiAl_{2.3}Ga_{0.7}N_4$:Eu | 0.01 | 39% | 56% | 3.06 | 647 | 53 | 0.691 | 0.307 | 0.998 |
| Phosphor 5 | $SrLiAl_{2-1}Ga_{0.9}N_4$:Eu | 0.01 | 33% | 48% | 2.60 | 643 | 54 | 0.686 | 0.312 | 0.998 |
| Phosphor 6 | $SrLiAl_{1.95}Ga_{1.05}N_4$:Eu | 0.01 | 32% | 52% | 2.37 | 641 | 55 | 0.680 | 0.318 | 0.998 |
| Phosphor 7 | $SrLiAl_{1.8}Ga_{1.2}N_4$:Eu | 0.02 | 30% | 46% | 2.34 | 639 | 55 | 0.678 | 0.320 | 0.998 |
| Phosphor 8 | $SrLiAl_{1.8}Ga_{1.2}N_4$:Eu | 0.01 | 26% | 44% | 1.97 | 637 | 56 | 0.674 | 0.324 | 0.998 |
| Phosphor 9 | $SrLiAl_{1.5}Ga_{1.5}N_4$:Eu | 0.01 | 21% | 45% | 1.26 | 633 | 59 | 0.661 | 0.337 | 0.998 |
| Phosphor 10 | $SrLiAl_{2.3}Ga_{0.7}N_4$:Eu | 0.01 | 2% | 3% | 0.11 | 639 | 58 | 0.660 | 0.330 | 0.991 |

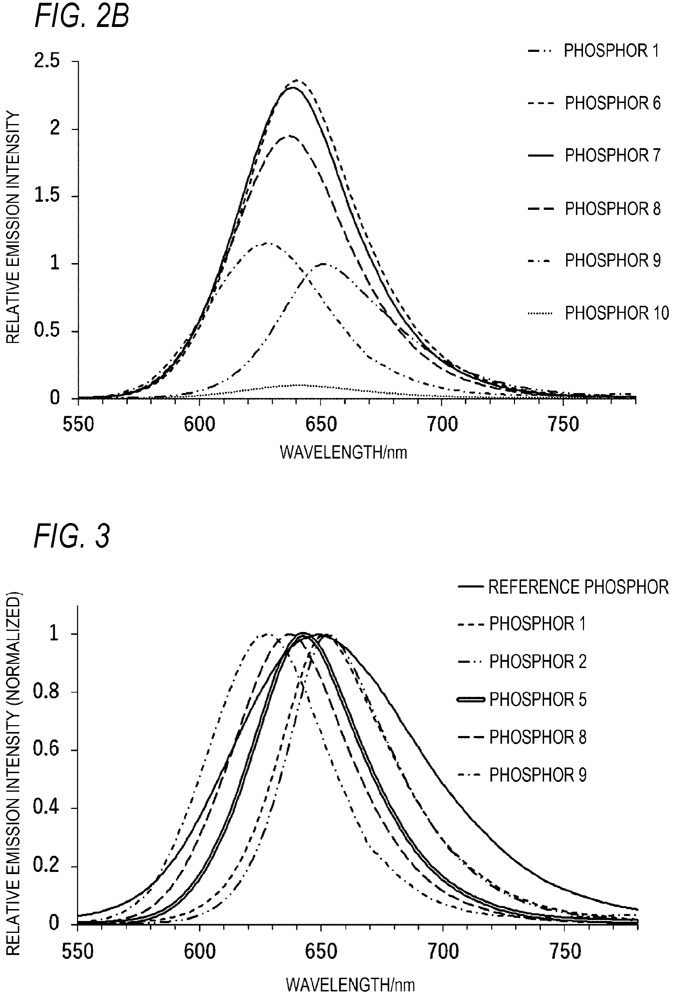

Fig 2A and Fig. 2B show a relationship between the emission intensity and the wavelengths of the phosphors 1 to 10.

As can be senn from Fig. 2A and Fig. 2B, the emission intensity of the phosphors 2 to 9 is dramatically improved compared to the phosphors 1 to 10.

In addition, Fig. 3 shows normalized emission spectra of the above phosphors and a CASN phosphor (BR-101/J, manufactured by Mitsubishi Chemical Corporation) having an emission peak wavelength of 646 nm as a reference phosphor. As can be seen from Fig. 3, the phosphor according to the present invention has a favorable emission spectrum with a narrow full width at half maximum, and the emission peak wavelength of the phosphors 5, 8, and 9 is shorter than that of the phosphor 1.

Note that powder X-ray diffraction patterns of the phosphors 1 to 10 all show favorable match with $SrLiAl_3N_4$.

<Comparative Example 1, Comparative Examples 3 and 4, Examples 1 to 7, and Example 15>

Assuming that a SCASN phosphor (BR2/620, manufactured by Mitsubishi Chemical Corporation) having an emission peak wavelength of 620 nm and satisfying neither the above (A) nor the above (B), was used as a first red phosphor, each phosphor shown in Table 1 was used as a second red phosphor, and a LuAG phosphor (BG-801/B4, manufactured by Mitsubishi Chemical Corporation) was used as a green phosphor, the emission spectrum of a white LED containing each phosphor was calculated based on information such as the emission spectrum and internal quantum efficiency (iQE) of each phosphor. All simulations were performed assuming a blue LED chip emitting light at 449 nm. In addition, for the purpose of confirming whether an emission spectrum having favorable conversion efficiency can be obtained with satisfying one of the typical standards required for the white LED, amounts of the green phosphor and the first and second red phosphors were adjusted such that all simulations were made to have an average color rendering index Ra of 90 or more, and a red color rendering index R9 of 50 or more, and to have the CIE chromaticity coordinates matched coordinates (0.437, 0.404) of 3000 K white light on the Planck curve, and the characteristics were compared.

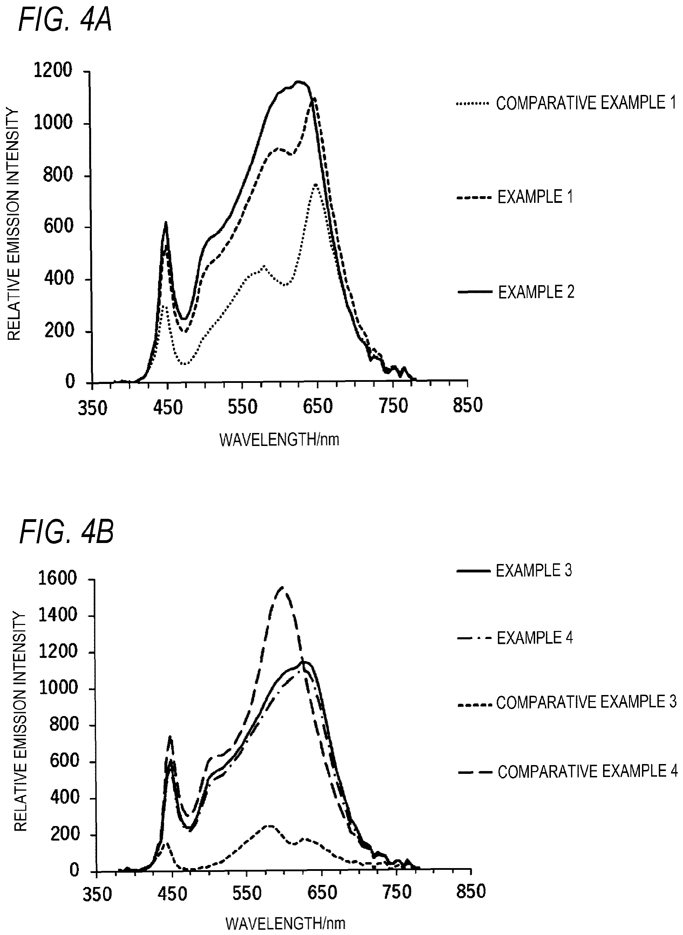

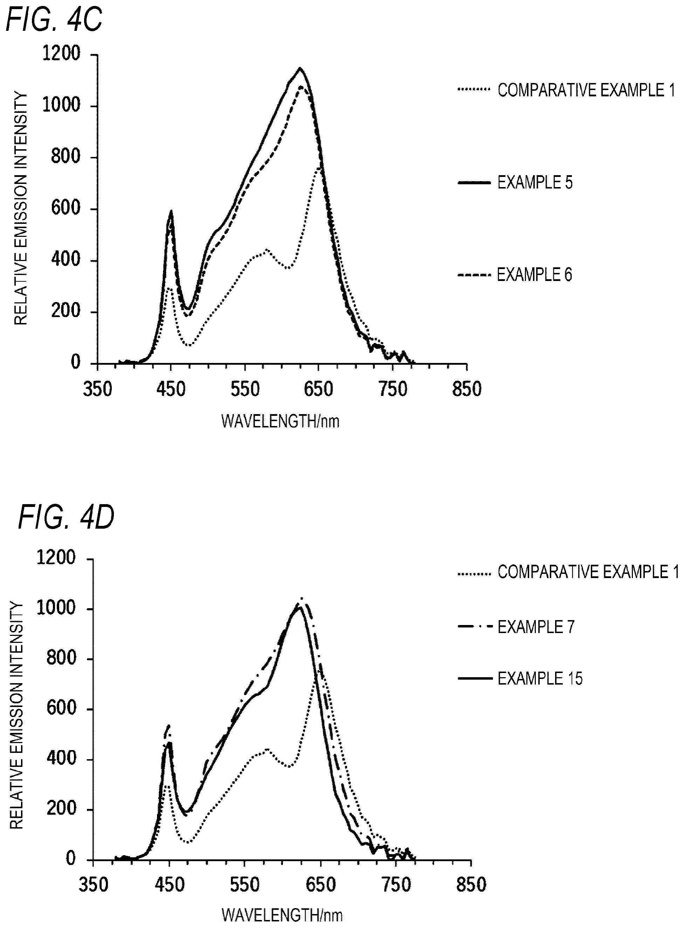

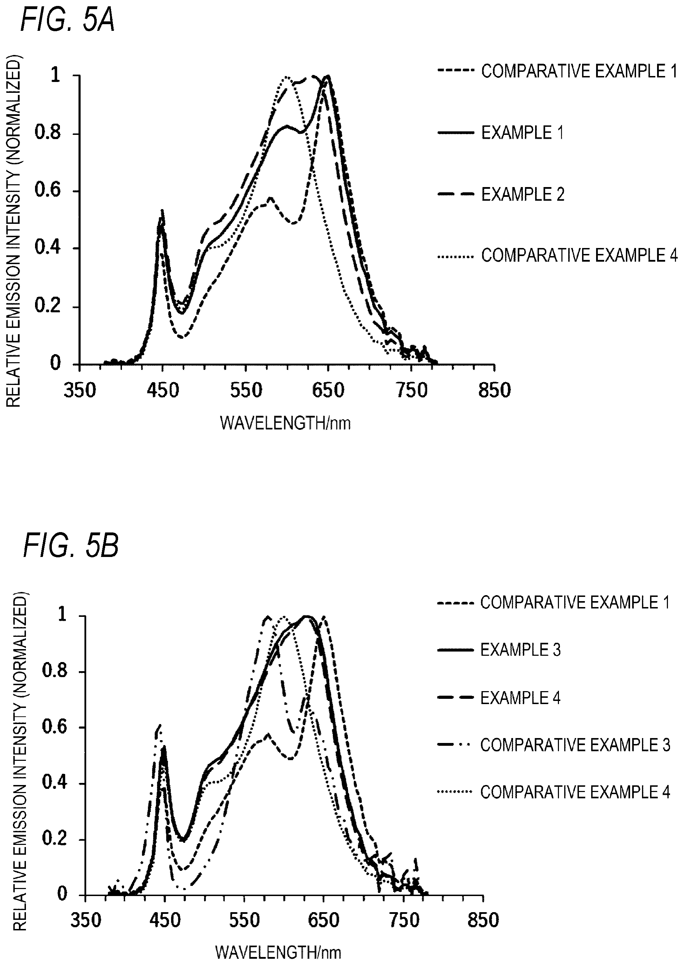

Regarding the white LEDs in Comparative Examples 1, 3 and 4, and Examples 1 to 7 and 15, Fig. 4A to Fig. 4D show simulation results of relative emission intensity, and Fig. 5A to Fig. 5E show simulation results of relative emission intensity when the emission intensity at an emission peak wavelength of each white LED is set to 1. In addition, Table 2 shows results of determining the average color rendering index Ra, the red color rendering index R9, and the spectral efficiency (LER), i.e., the luminous flux (Lm) per energy (Wopt) of the emission spectrum, which is one index of the conversion efficiency, from each spectrum.

<Comparative Example 2, Comparative Examples 5 and 6, Examples 8 to 14, and Example 16>

Simulations were conducted in the same manner as in Comparative Example 1 and Examples 1 to 7, except that as Comparative Examples 2, 5, and 6 and Examples 8 to 14 and 16, the CIE chromaticity coordinates were made to match coordinates (0.380, 0.377) of 4000 K white light on the Planck curve.

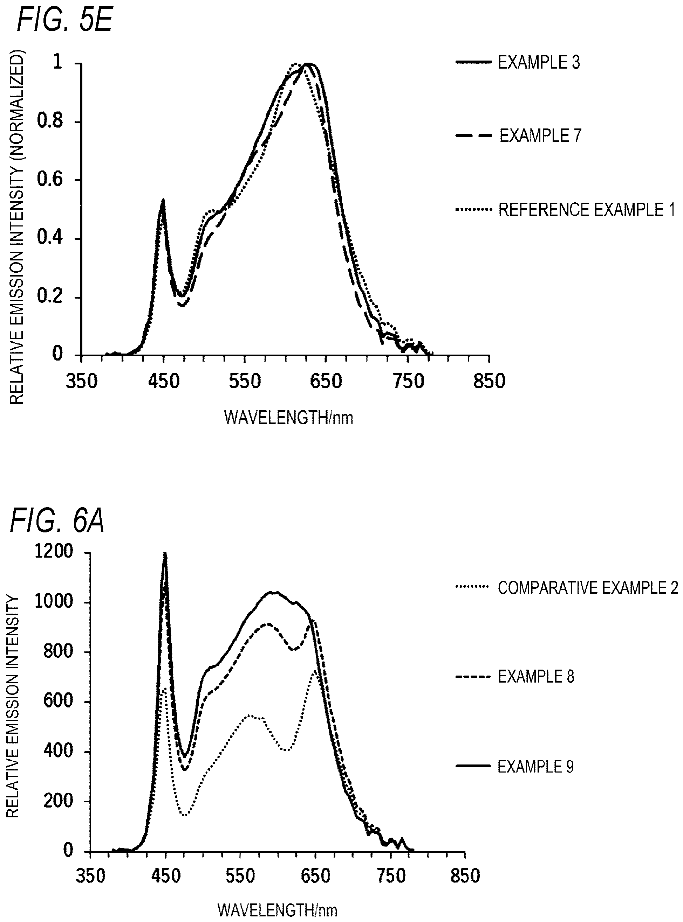

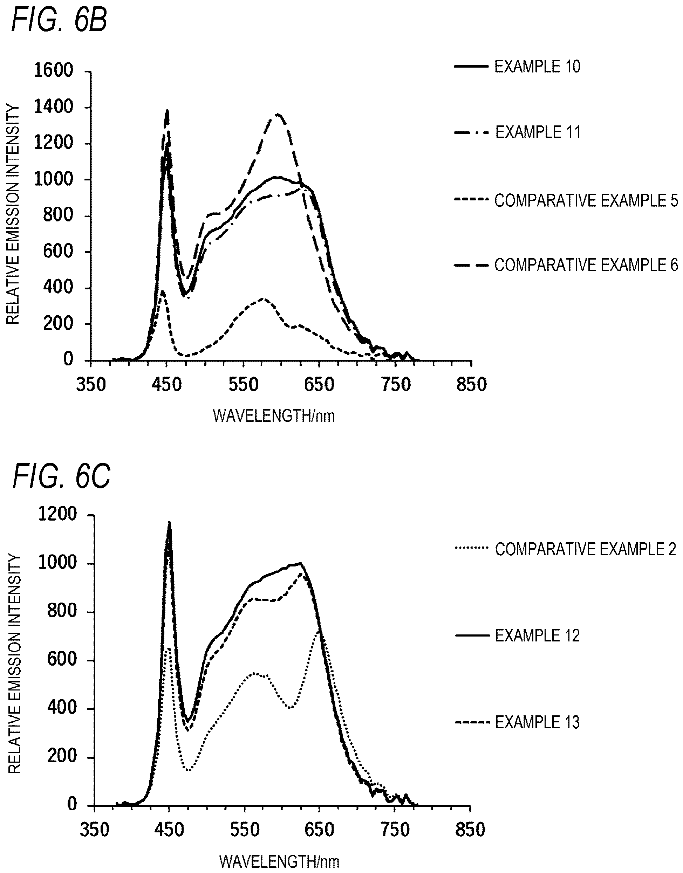

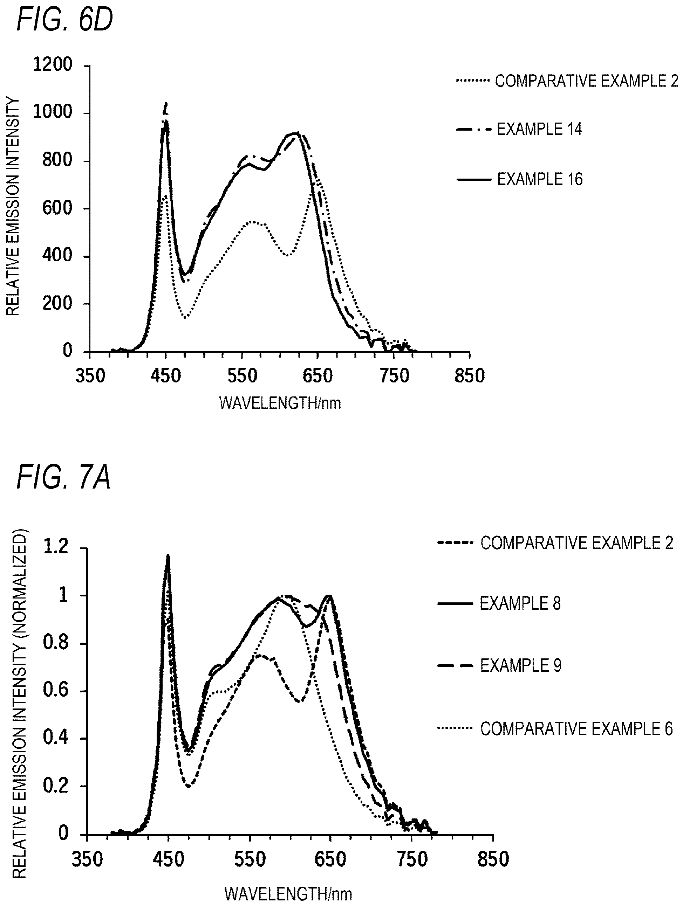

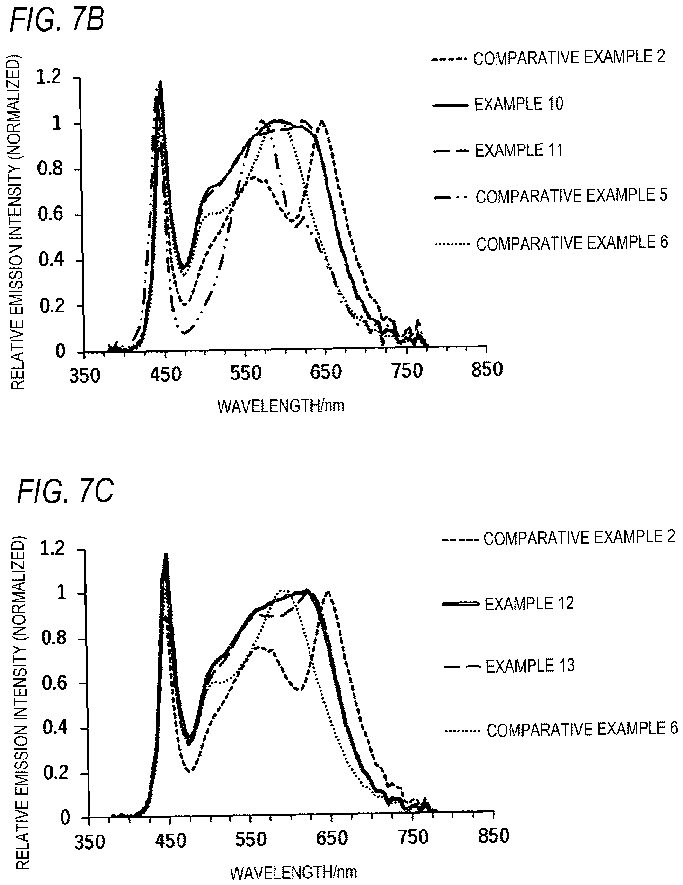

Regarding the white LEDs in Comparative Examples 2, 5, and 6 and Examples 8 to 14 and 16, Fig. 6A to Fig. 6D show simulation results of relative emission intensity, and Fig. 7A to Fig. 7E show simulation results of relative emission intensity when the emission intensity at an emission peak wavelength present in a wavelength region of 500 nm or more and 780 nm or less of each white LED is set to 1. In addition, Table 3 shows results of determining the average color rendering index Ra, the red color rendering index R9, and the spectral efficiency (LER) from each spectrum.

Note that, in Table 2 and Table 3, "ratio/wt%" of a phosphor is a weight proportion of each phosphor when the total weight of the phosphors is 100%, "Green" is the LuAG phosphor, "Red 1" is the first red phosphor, and "Red 2" is the second red phosphor.

Table 2

| | wavelength/nm | Green (LuAG) ratio/wt% | Red 1 (SCASN) ratio/wt% | Red 2 type | Red 2 ratio/wt% | White color coordinate x | White color coordinate y | Color temperature/K | LER Lm/W_opt | Ra | R9 |
|---|---|---|---|---|---|---|---|---|---|---|---|
| Comparative Example 1 | 449 | 32.1% | 0.0% | Phosphor 1 | 67.9% | 0.437 | 0.404 | 3000 | 259.5 | 90 | 89 |
| Example 1 | 449 | 78.8% | 6.4% | Phosphor 2 | 14.8% | 0.437 | 0.404 | 3000 | 287.5 | 93 | 69 |
| Example 2 | 449 | 83.3% | 7.5% | Phosphor 3 | 92% | 0.437 | 0.404 | 3000 | 307.7 | 92 | 53 |
| Example 3 | 449 | 82.4% | 7.0% | Phosphor 4 | 10 6% | 0.437 | 0.404 | 3000 | 309.1 | 92 | 53 |
| Example 4 | 449 | 80.5% | 5.9% | Phosphor 5 | 13.7% | 0.437 | 0.404 | 3000 | 312.2 | 92 | 53 |
| Example 5 | 449 | 74.5% | 5.1% | Phosphor 6 | 20 4% | 0.437 | 0.404 | 3000 | 315.8 | 91 | 51 |
| Example 6 | 449 | 70.9% | 29% | Phosphor 7 | 26.2% | 0.437 | 0.404 | 3000 | 312.8 | 93 | 63 |
| Example 7 | 449 | 59.9% | 2.8% | Phosphor 8 | 32.2% | 0.437 | 0.404 | 3000 | 317.6 | 91 | 54 |
| Example 15 | 449 | 41.9% | 0.0% | Phosphor 9 | 58.1% | 0.437 | 0.404 | 3000 | 328.8 | 91 | 46 |
| Comparative Example 3 | 449 | 35.2% | 0.0% | Phosphor 10 | 64.8% | 0.437 | 0.404 | 3000 | 338.1 | 59 | -39 |
| Comparative Example 4 | 449 | 84.8% | 13.7% | Phosphor 10 | 1.5% | 0437 | 0.404 | 3000 | 341.4 | 79 | -17 |
| Reference Example 1 | 449 | 46.9% | 3.5% | CASN/J | 13.9% | 0.437 | 0.404 | 3000 | 289.3 | 94 | 60 |

CIE chromaticity coordinates: (0.437, 0.404), color temperature: 3000 K

Table 3

| | Light source wavelength/m | Green (LuAG) ratio/wt% | Red 1 (SCAN) ratio/wt% | Red 2 type | Red 2 ratio/wt% | While color coordinate x | White color coordinate y | Color temperature/K | $\frac{LER}{Lm/W_{opt}}$ | Ra | R9 |
|---|---|---|---|---|---|---|---|---|---|---|---|
| Comparative Example 2 | 449 | 34.5% | 0.0% | Phosphor 1 | 65.5% | 0.380 | 0.377 | 4000 | 274.0 | 88 | 97 |
| Example 8 | 449 | 81.0% | 5.7% | Phosphor 2 | 13.3% | 0380 | 0.377 | 4000 | 295.4 | 91 | 65 |
| Example 9 | 449 | 85.2% | 61% | Phosphor 3 | 8.2% | 0.380 | 0.377 | 4000 | 309.4 | 91 | 54 |
| Example 10 | 449 | 84.4% | 6.2% | Phosphor 4 | 9.4% | 0.380 | 0.377 | 4000 | 310.4 | 91 | 54 |
| Example 11 | 449 | 82.1% | 4.5% | Phosphor 5 | 13.4% | 0.380 | 0.377 | 4000 | 310.3 | 91 | 61 |
| Example 12 | 449 | 77.4% | 4.5% | Phosphor 6 | 18.1% | 0.380 | 0.377 | 4000 | 315.1 | 91 | 53 |
| Example 13 | 449 | 74.0% | 2.6% | Phosphor 7 | 23.4% | 0.380 | 0.377 | 4000 | 312.9 | 92 | 65 |
| Example 14 | 449 | 66.9% | 1.7% | Phosphor 8 | 31.4% | 0.380 | 0.377 | 4000 | 314.1 | 91 | 64 |
| Example 16 | 449 | 45.9% | 0.0% | Phosphor 9 | 54.1% | 0.380 | 0.377 | 4000 | 324.0 | 91 | 51 |
| Comparative Example 5 | 449 | 41.5% | 0.0% | Phosphor 10 | 58.5% | 0.380 | 0.377 | 4000 | 341.6 | 61 | -51 |
| Comparative Example 6 | 449 | 86.9% | 11.8% | Phosphor 10 | 1.3% | 0.380 | 0377 | 4000 | 333.0 | 83 | -5 |
| CIE chromaticity coordinates: (0.380, 0.377), color temperature: 4000 K | | | | | | | | | | | |

In the specifications of Ra ≥ 90 and R9 ≥ 50, the spectral efficiency LER of Examples 1 to 7 and 15 is significantly improved compared to Comparative Example 1, and the spectral efficiency LER of Examples 8 to 14 and 16 is significantly improved compared to Comparative Example 2.

Note that regarding Comparative Examples 1 and 2 using the phosphor 1 whose chromaticity coordinates of the red phosphor do not meet the requirements of the present invention, a large amount of the second red phosphor is required to satisfy Ra and a correlated color temperature, R9 is higher than necessary, but LER is low.

In contrast, regarding Examples 1 and 8 using the phosphor 2, it is successful to improve LER with ensuring a necessary R9, and regarding Examples in which the phosphors 3 to 9 having an emission peak wavelength below 650 nm are used as the red phosphor 2, the effect is even more remarkable.

From another viewpoint, as can be seen from Fig. 5A and Fig. 7A, Examples corresponding to the embodiment of the present invention include red and green regions in a well-balanced manner compared to Comparative Examples 1 and 2, and as a result, the spectral efficiency is improved.

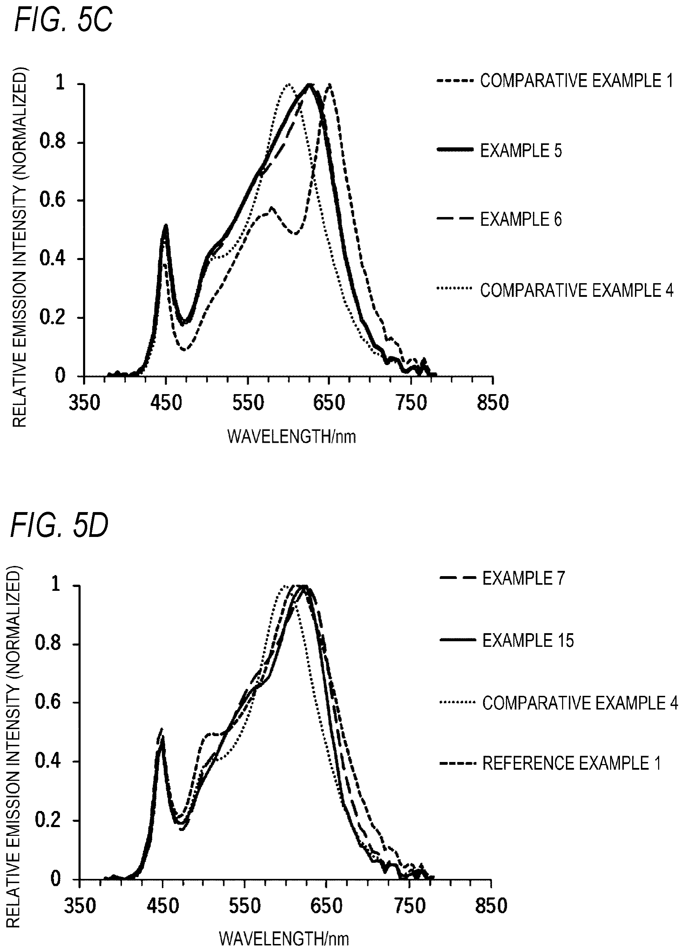

In addition, as can be seen from Fig. 5C, Examples corresponding to the embodiment of the present invention have a preferred emission intensity in the red region and as a result, have an ensured R9, compared to examples such as Comparative Example 4, and have succeeded in improving LER compared to Comparative Example 1 by reducing the emission intensity in the wavelength region of 660 nm or more where the relative visibility is low, and a light-emitting device having favorable color rendering and conversion efficiency can be obtained. As can be seen from Fig. 7A and Fig. 7C, by comparing Comparative Examples 2 and 6 with each Example, similar effects can be obtained even with light emission colors showing different correlated color temperatures.

In addition, in the case of using the phosphor 10, a plurality of patterns for combinations of phosphors are tried, but an emission spectrum with Ra ≥ 90 and R9 ≥ 50 cannot be obtained in any case.

As typical patterns, Comparative Examples 3 and 5 are shown in which a large amount of the phosphor 10 is used, and Comparative Examples 4 and 6 are shown in which a green phosphor is used entirely without using a large amount of a red phosphor.

In all cases, the red color rendering R9 is a negative value in calculation, and this cannot be considered as an accurate value, and means that the red color rendering is too low to be accurately calculated.

<Reference Example 1>

A simulation was conducted in the same manner as in Example 1, except that a CASN phosphor (BR-101/J, manufactured by Mitsubishi Chemical Corporation) having an emission peak wavelength of 646 nm was used instead of the second red phosphor.

Fig. 5D and Fig. 5E show a normalized relative emission intensity in Reference Example 1 and a normalized relative emission intensity in each Example.

In addition, Table 2 shows various characteristics of a white LED of Reference Example 1.

<Reference Example 2>

A simulation was conducted in the same manner as in Example 8, except that a CASN phosphor (BR-101/J, manufactured by Mitsubishi Chemical Corporation) having an emission peak wavelength of 646 nm was used instead of the second red phosphor.

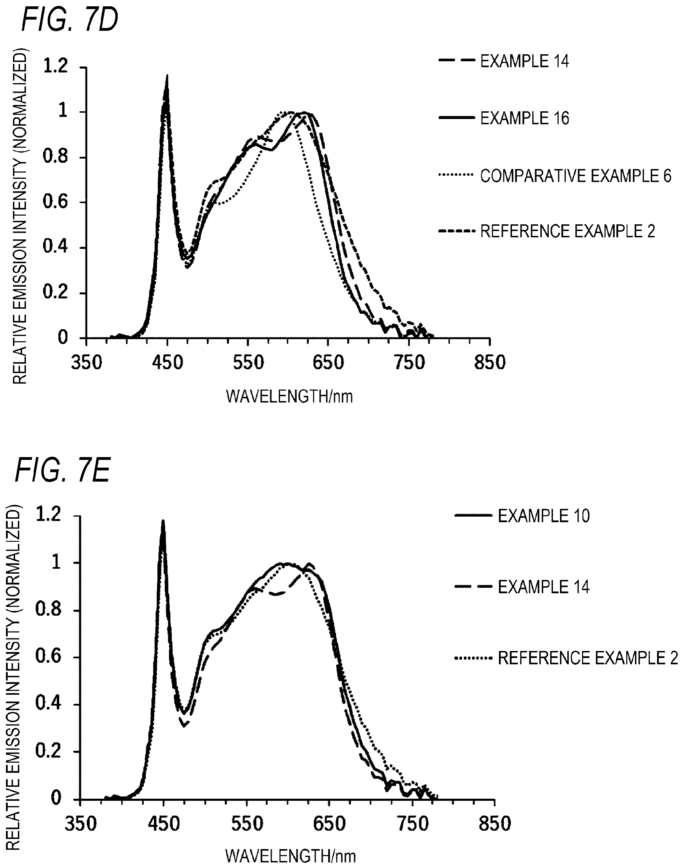

Fig. 7D and Fig. 7E show a normalized relative emission intensity in Reference Example 2 and a normalized relative emission intensity in each Example when the maximum emission intensity in a wavelength region of 480 nm to 780 nm is set to 1.

As can be seen from these figures, the light-emitting device according to the present invention has a sharp peak in the red region and can reduce the emission intensity in a wavelength region of 680 nm or more, where the relative visibility is low, and a light-emitting device having high color rendering or red color reproducibility and high conversion efficiency can be provided.

As shown above, according to the present embodiment, it is possible to provide a phosphor having a favorable emission peak wavelength, a narrow full width at half maximum in the emission spectrum, and/or a high emission intensity, and when this phosphor is contained, it is possible to provide a light-emitting device, an illumination device, an image display device, and/or an indicator lamp for a vehicle which have favorable color rendering or color reproducibility and favorable conversion efficiency.

Although various embodiments have been described above with reference to the drawings, it goes without saying that the present invention is not limited to such examples. It is clear that the person skilled in the art can conceive various changes or modifications within the scope of the claims, and it is understood that these also naturally fall within the technical scope of the present invention. In addition, each of the constituent elements in the above embodiments may be freely combined without departing from the spirit of the invention.

Although various embodiments have been described above, it goes without saying that the present invention is not limited to such examples. It is clear that the person skilled in the art can conceive various changes or modifications within the scope of the claims, and it is understood that these also naturally fall within the technical scope of the present invention. In addition, each of the constituent elements in the above embodiments may be freely combined without departing from the spirit of the invention.

Note that the present application is based on a Japanese patent application No. 2022-210188 filed on December 27, 2022, the content of which is incorporated by reference into the present application.

INDUSTRIAL APPLICABILITY

The light-emitting device according to the present invention is favorable in any one or more of color rendering, color reproducibility, conversion efficiency, safety, and a contrast, and can be thus used for an illumination device, an image display device, and an indicator lamp for a vehicle.

**Claims**

1. A light-emitting device comprising:

    a first luminescent material; and
    a second luminescent material which emits visible light by irradiation with light from the first luminescent material, wherein the second luminescent material contains at least a red phosphor which satisfies the following (A) and (B):

        (A) an emission spectrum has at least one emission peak having a full width at half maximum (FWHM) of 20 nm or more and 65 nm or less, and
        (B) chromaticity coordinates of a light emission color are present between two straight lines represented by the following equation (a) and equation (b) based on coordinates represented by (x, y) in a CIE 1931 chromaticity coordinate system:

$$y = 0.992\text{-x} \qquad (a),$$

$$y = 1.000\text{-x} \qquad (b),$$

    and

$$0.290 \le y \le 0.350.$$

2. The light-emitting device according to claim 1, wherein a value of y of chromaticity coordinates of red light emitted by the red phosphor is 0.300 or more.

3. The light-emitting device according to claim 1 or 2, wherein the value of y of the chromaticity coordinates of the red light emitted by the red phosphor is 0.310 or less.

4. The light-emitting device according to claim 1 or 2, wherein the red phosphor comprises a phosphor which does not substantially include Mn.

5. The light-emitting device according to claim 1 or 2, wherein the emission spectrum of the red phosphor comprises at least one emission peak having an emission peak wavelength of 648 nm or less.

6. The light-emitting device according to claim 1 or 2, wherein internal quantum efficiency of the red phosphor is 30% or more.

7. The light-emitting device according to claim 1 or 2, wherein the red phosphor has the full width at half maximum in the emission spectrum of 57 nm or less.

8. The light-emitting device according to claim 1 or 2, wherein the red phosphor has an emission peak wavelength x (nm) and a full width at half maximum y (nm) in the emission spectrum satisfying a relationship: $y \leq 184-0.2x$.

9. The light-emitting device according to claim 1 or 2, wherein the red phosphor comprises at least a phosphor containing a crystal phase having a composition represented by the following formula [1]:

$$Re_x MA_a MB_b MC_c N_d X_e \qquad [1]$$

wherein in formula [1], MA includes one or more elements selected from the group consisting of Sr, Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

10. The light-emitting device according to claim 1 or 2, wherein the red phosphor comprises at least a phosphor containing a crystal phase having a composition represented by the following formula [2]:

$$Re_x MA_a MB_b (MC'_{1-y} MD_y)_c N_d X_e \qquad [2]$$

wherein in formula [2], MA includes one or more elements selected from the group consisting of Sr, Ca, Ba, Na, K, Y, Gd, and La,
MB includes one or more elements selected from the group consisting of Li, Mg, and Zn,
MC' is Al,
MD includes one or more elements selected from the group consisting of Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

11. The light-emitting device according to claim 1 or 2, wherein the red phosphor comprises at least a phosphor containing a crystal phase having a composition represented by the following formula [3]:

$$Re_xMA_aMB_bMC_c(N,O)_dX_e \qquad [3]$$

wherein in formula [3], (N,O) means containing N and O,
MA includes one or more elements selected from the group consisting of Sr, Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

12. The light-emitting device according to claim 1 or 2, wherein the red phosphor comprises at least a phosphor containing a crystal phase having a composition represented by the following formula [4]:

$$Re_xMA_aMB_b(MC'_{1-y}MD_y)_c(N,O)_dX_e \qquad [4]$$

wherein in formula [4], (N,O) means containing N and O,
MA includes one or more elements selected from the group consisting of Sr, Ca, Ba, Na, K, Y, Gd, and La,
MB includes one or more elements selected from the group consisting of Li, Mg, and Zn,
MC' is Al,
MD includes one or more elements selected from the group consisting of Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

13. The light-emitting device according to claim 1 or 2, wherein the second light emitter further comprises a yellow phosphor and/or a green phosphor.

14. The light-emitting device according to claim 13, wherein the yellow phosphor and/or the green phosphor comprises any one or more of a garnet type phosphor, a silicate type phosphor, a nitride phosphor, and an oxynitride phosphor.

15. An illumination device comprising the light-emitting device according to claim 1 or 2 as a light source.

16. An image display device comprising the light-emitting device according to claim 1 or 2 as a light source.

17. An indicator lamp for a vehicle comprising the light-emitting device according to claim 1 or 2 as a light source.

## FIG. 1

Legend:
- ✱ PHOSPHOR 1
- ○ PHOSPHORS 2 TO 9
- ✕ PHOSPHOR 10

$y = 0.992-x$

$y = 1.000-x$

## FIG. 2A

Legend:
- — ·· PHOSPHOR 1
- — — PHOSPHOR 2
- ----- PHOSPHOR 3
- —— PHOSPHOR 4
- ▬▬ PHOSPHOR 5

X-axis: WAVELENGTH/nm
Y-axis: RELATIVE EMISSION INTENSITY

*FIG. 2B*

*FIG. 3*

## FIG. 4A

## FIG. 4B

## FIG. 4C

## FIG. 4D

*FIG. 5A*

*FIG. 5B*

*FIG. 5C*

*FIG. 5D*

## FIG. 5E

Legend:
— EXAMPLE 3
– – EXAMPLE 7
······· REFERENCE EXAMPLE 1

X-axis: WAVELENGTH/nm (350, 450, 550, 650, 750, 850)
Y-axis: RELATIVE EMISSION INTENSITY (NORMALIZED) (0, 0.2, 0.4, 0.6, 0.8, 1)

## FIG. 6A

Legend:
········ COMPARATIVE EXAMPLE 2
----- EXAMPLE 8
— EXAMPLE 9

X-axis: WAVELENGTH/nm (350, 450, 550, 650, 750, 850)
Y-axis: RELATIVE EMISSION INTENSITY (0, 200, 400, 600, 800, 1000, 1200)

## FIG. 6B

## FIG. 6C

## FIG. 6D

- ·········· COMPARATIVE EXAMPLE 2
- — · — EXAMPLE 14
- ——— EXAMPLE 16

## FIG. 7A

- - - - - COMPARATIVE EXAMPLE 2
- ——— EXAMPLE 8
- — — EXAMPLE 9
- ·········· COMPARATIVE EXAMPLE 6

## FIG. 7B

## FIG. 7C

## FIG. 7D

- ─ ─ EXAMPLE 14
- ──── EXAMPLE 16
- ·········· COMPARATIVE EXAMPLE 6
- ─ ─ ─ REFERENCE EXAMPLE 2

## FIG. 7E

- ──── EXAMPLE 10
- ─ ─ EXAMPLE 14
- ·········· REFERENCE EXAMPLE 2

## INTERNATIONAL SEARCH REPORT

| International application No. |
| --- |
| **PCT/JP2023/028194** |

| A. | CLASSIFICATION OF SUBJECT MATTER |
| --- | --- |

*H01L 33/50*(2010.01)i; *C09K 11/08*(2006.01)i; *C09K 11/59*(2006.01)i; *C09K 11/61*(2006.01)i; *C09K 11/62*(2006.01)i; *C09K 11/64*(2006.01)i; *C09K 11/79*(2006.01)i; *C09K 11/80*(2006.01)i; *C09K 11/85*(2006.01)i; *F21K 9/60*(2016.01)i; *F21K 9/64*(2016.01)i; *F21S 41/125*(2018.01)i; *F21S 41/141*(2018.01)i; *F21S 41/176*(2018.01)i; *F21V 9/38*(2018.01)i; *F21W 102/00*(2018.01)n; *F21W 102/30*(2018.01)n; *F21W 103/15*(2018.01)n; *F21W 103/20*(2018.01)n; *F21W 103/35*(2018.01)n; *F21W 103/45*(2018.01)n; *F21Y 115/10*(2016.01)n

FI: H01L33/50; C09K11/08 J; C09K11/59; C09K11/61; C09K11/62; C09K11/64; C09K11/79; C09K11/80; C09K11/85; F21K9/60; F21K9/64; F21S41/125; F21S41/141; F21S41/176; F21V9/38; F21W102:00; F21W102:30; F21W103:15; F21W103:20; F21W103:35; F21W103:45; F21Y115:10 100; F21Y115:10 300; F21Y115:10 500

According to International Patent Classification (IPC) or to both national classification and IPC

| B. | FIELDS SEARCHED |
| --- | --- |

Minimum documentation searched (classification system followed by classification symbols)

H01L33/00-33/64; C09K11/08; C09K11/59; C09K11/62; C09K11/64; C09K11/77-11/86

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | FANG, Mu-Huai, et al. Chemical Control of SrLi(Al1-xGax)3N4:Eu2+ Red Phosphors at Extreme Conditions for Application in Light-Emitting Diodes. Chemistry of Materials. 28 May 2019, vol. 31, pp. 4614-4618 | 1-8, 15-17 |
| | p. 4614, left column, line 1 to p. 4616, left column, line 7, fig. 1-2, supporting information, tables S2-S3 | |
| Y | p. 4614, left column, line 1 to p. 4616, left column, line 7, fig. 1-2, supporting information, tables S2-S3 | 9-10, 13-14 |
| A | p. 4614, left column, line 1 to p. 4616, left column, line 7, fig. 1-2, supporting information, tables S2-S3 | 11-12 |

☑ Further documents are listed in the continuation of Box C.     ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 September 2023** | **03 October 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT

# EP 4 646 071 A1

**INTERNATIONAL SEARCH REPORT**

International application No.

**PCT/JP2023/028194**

**C. DOCUMENTS CONSIDERED TO BE RELEVANT**

| Category* | Citation of document, with indication, where appropriate, of the relevant passages | Relevant to claim No. |
|---|---|---|
| X | JP 2017-155209 A (NICHIA CORPORATION) 07 September 2017 (2017-09-07) paragraphs [0003]-[0007], [0014]-[0041], [0068]-[0119], fig. 1-3 | 1-9, 13-17 |
| Y | paragraphs [0003]-[0007], [0014]-[0041], [0068]-[0119], fig. 1-3 | 9-10, 13-14 |
| X | WO 2019/188319 A1 (DENKA CO., LTD.) 03 October 2019 (2019-10-03) paragraphs [0013], [0032], [0061], [0063], [0065], [0098]-[0099] | 1-17 |

Form PCT/ISA/210 (second sheet) (January 2015)

**INTERNATIONAL SEARCH REPORT**
Information on patent family members

International application No.

**PCT/JP2023/028194**

| Patent document cited in search report | | | Publication date (day/month/year) | Patent family member(s) | Publication date (day/month/year) |
|---|---|---|---|---|---|
| JP | 2017-155209 | A | 07 September 2017 | US 2017/0250320 A1<br>paragraphs [0006]-[0009],<br>[0025]-"0058], [0093]-[0152],<br>fig. 1-3 | |
| WO | 2019/188319 | A1 | 03 October 2019 | US 2021/0017448 A1<br>paragraphs [0015], [0040],<br>[0090], [0093], [0095], [0140]-<br>[0141]<br>CN 111902516 A<br>KR 10-2020-0135793 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006008721 A
- JP 2017008130 A
- JP 2022210188 A

**Non-patent literature cited in the description**

- *J. Mater. Chem. C*, 2015, vol. 3 (21), 5484-5489
- *Chemistry Letters*, 2006, vol. 35 (3), 334-335
- *Chemistry of Materials*, 2019, vol. 31 (12), 4614-4618